# EUROPEAN PATENT APPLICATION

(11) **EP 4 686 350 A1**
(43) Date of publication of application: **28.01.2026**
(21) Application number: 25186037.5
(22) Date of filing: 27.06.2025
(51) Int. Cl.: H10H 29/37, H10H 29/39, H10H 29/49, H10H 29/80

(54) **DISPLAY DEVICE**

(30) Priority: 25.07.2024 KR 20240098861
(71) Applicant: LG Display Co., Ltd., Seoul, 07336 (KR)
(72) Inventor: LEE, Jae Kwang, 10845 Gyeonggi-do (KR); JUNG, Kyoung June, 10845 Gyeonggi-do (KR)
(74) Representative: Morrall, Jonathan Ian McLachlan

(57) **Abstract**

A display device according to an embodiment of the present specification may include a substrate including a display area and a non-display area, first electrodes disposed on the substrate, a light-emitting element disposed on each of the first electrodes, and a first passivation layer disposed on the first electrode. The first electrodes may include a first driving electrode disposed in the display area and a first dummy electrode disposed in the non-display area. The first passivation layer may include a first opening disposed on the first dummy electrode.

## Description

### CROSS-REFERENCE TO RELATED APPLICATION

This application claims priority to and the benefit of Korean Patent Application No. 10-2024-0098861, filed in the Republic of Korea on July 25, 2024, the entire disclosure of which is incorporated herein by reference for all purposes, as if fully set forth herein.

### 1. Technical Field

The present specification relates to a display device, and particularly to, for example, without limitation, a display device with improved reliability.

### 2. Discussion of Related Art

Display devices are being applied to various electronic devices such as TVs, mobile phones, laptop computers, and tablets.

Display devices include organic light-emitting display (OLED) devices, which are self-emissive, liquid crystal display (LCD) devices, which require a separate light source, and the like.

In recent years, display devices including light-emitting diodes (LEDs) have been gaining attention as next-generation display devices. Since LEDs are formed of inorganic materials rather than organic materials, the display devices including LEDs have a fast lighting speed and high luminous efficacy, and can display high-brightness images compared to liquid crystal display devices and organic light-emitting display devices.

As another example, micro LEDs may be used as light-emitting elements.

The description provided in the background section should not be assumed to be prior art merely because it is mentioned in or associated with the background section. The background section may include information that describes one or more aspects of the subject technology.

### SUMMARY

It is newly recognized by inventors of the present application that, in the case of a display device using micro light emitting diodes (micro LEDs), a large amount of gas may be generated during the manufacturing process due to the stacking of multiple layers containing organic materials. However, there may be a situation in which the gas cannot be discharged to the outside (for example, when an inorganic layer is stacked on the organic layer). As a result, there is a problem in which the reliability of the display device is degraded.

One or more aspects of the present specification is to provide a display device with improved reliability.

Aspects according to embodiments of the present specification are not limited to the above-described aspects, and other aspects that are not described herein will be apparently understood by those skilled in the art from the following description.

To achieve these and other aspects of the inventive concepts, as embodied and broadly described herein, a display device according to an example embodiment of the present specification includes a substrate including a display area and a non-display area, first electrodes disposed on the substrate, a light-emitting element disposed on each of the first electrodes, and a first passivation layer disposed on the first electrode. The first electrodes may include a first driving electrode disposed in the display area and a first dummy electrode disposed in the non-display area. The first passivation layer may include a first opening disposed on the first dummy electrode.

According to embodiments of the present disclosure, it is possible to provide a display device with improved reliability.

The effects of the embodiments of the present disclosure are not limited to the effects mentioned above, and other effects not mentioned will be clearly understood by those skilled in the art from the description of the claims.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, that may be included to provide a further understanding of the disclosure and may be incorporated in and constitute a part of the disclosure, illustrate embodiments of the disclosure and together with the description serve to explain various principles of the disclosure.

The above and other aspects, features, and advantages of the present disclosure will become more apparent to those of ordinary skill in the art by describing exemplary embodiments thereof in detail with reference to the accompanying drawings, in which:
FIG. 1 is an exploded perspective view of a display device according to an example embodiment of the present specification;
FIG. 2 is a plan view of the display device according to the example embodiment of the present specification;
FIG. 3 is an enlarged view of the display device according to the example embodiment of the present specification;
FIG. 4 is a diagram illustrating a circuit structure according to an example embodiment of the present specification;
FIG. 5 is a plan view of a display device according to an example embodiment of the present specification;
FIG. 6 is a plan view of the display device according to the example embodiment of the present specification;
FIG. 7 is a plan view of the display device according to the example embodiment of the present specification;
FIGS. 8A and 8B are cross-sectional views of the display device according to the example embodiment of the present specification;
FIG. 9 is a cross-sectional view of the display device according to the example embodiment of the present specification;
FIG. 10 is an enlarged view of a display device according to an example embodiment of the present specification;
FIG. 11 is a cross-sectional view of the display device according to the example embodiment of the present specification;
FIG. 12A is a cross-sectional view illustrating a second dummy area of the display device according to the example embodiment of the present specification;
FIG. 12B is a plan view illustrating a first dummy electrode of the display device according to the example embodiment of the present specification;
FIG. 13 is a cross-sectional view of the display device according to the example embodiment of the present specification;
FIG. 14 is a cross-sectional view of the display device according to the example embodiment of the present specification;
FIGS. 15 and 16 are views illustrating a state in which an alignment key is exposed, according to the example embodiment of the present specification;
FIG. 17 is a view illustrating a state in which second alignment keys are disposed outside a display device according to an example embodiment of the present specification;
FIG. 18 is a cross-sectional view of the display device according to the example embodiment of the present specification;
FIG. 19 is a cross-sectional view of the display device according to the example embodiment of the present specification;
FIG. 20 is an example of a view illustrating a state in which the second alignment key is delaminated;
FIG. 21 is a cross-sectional view of the display device according to the example embodiment of the present specification; and
FIGS. 22 to 25 are views illustrating devices to which the display devices according to the example embodiments of the present specification are applied.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF EXEMPLARY EMBODIMENTS

Reference will now be made in detail to embodiments of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations may be selected only for convenience of writing the specification and may be thus different from those used in actual products.

Advantages and features of the present specification and a method of achieving the same should become clear with example embodiments described in detail below with reference to the accompanying drawings. However, the present specification is not limited to the example embodiments described below and may be implemented in various different forms. The example embodiments are merely provided to allow those skilled in the art to completely understand the scope of the present specification. Any implementation described herein as an "example" is not necessarily to be construed as preferred or advantageous over other implementations.

The shapes, dimensions, ratios, angles, numbers, and the like disclosed in the drawings for describing the embodiments of the present specification are merely illustrative and are not limited to matters shown in the present specification. Like reference numerals refer to like elements throughout the specification. Further, in describing the present specification, detailed descriptions of well-known technologies will be omitted when it is determined that they may unnecessarily obscure the gist of the present specification. Terms such as "including," "having," and "composed of' used herein are intended to allow other elements to be added unless the terms are used with a more limiting term such as "only." An element described in the singular form is intended to include a plurality of elements, and vice versa, unless the context clearly indicates otherwise.

Components are interpreted as including an ordinary error range or tolerance range even if there is no explicit description of such an error or tolerance range.

Where positional relationships are described, for example, where the positional relationship between two parts is described using "on," "over," "under," "above," "below," "beneath," "near," "close to," or "adjacent to," "beside," "next to," or the like, one or more other parts may be disposed between the two parts unless a more limiting term, such as "immediate(ly)," "direct(ly)," or "close(ly)" is used. For example, when a structure is described as being positioned "on," "over," "under," "above," "below," "beneath," "near," "close to," or "adjacent to," "beside," or "next to" another structure, this description should be construed as including a case in which the structures contact each other as well as a case in which a third structure is disposed or interposed therebetween. Furthermore, the terms "left," "right," "top," "bottom, "downward," "upward," "upper," "lower," and the like refer to an arbitrary frame of reference.

In describing a temporal relationship, when the temporal order is described as, for example, "after," "following," "subsequent," "next," and "before," a case that is not continuous may be included unless a more limiting term, such as "just," "immediate(ly)," or "direct(ly)" is used.

Although the terms "first," "second," and the like may be used herein to describe various components, the essence, sequence, order, or number of the components are not limited by the terms. These terms are used only to distinguish one component from another. For example, a first component could be termed a second component, and, similarly, a second component could be termed a first component, without departing from the scope of the present disclosure.

Terms such as first, second, A, B, (a), (b), or the like may be used herein when describing components of the present specification. Such terms are used only to distinguish a component from another component, but do not limit the nature, sequence, order, number, or the like of components.

It is to be understood that when a component is described as being "connected," "coupled," "linked," or "attached" to another component, the component may be directly connected, coupled, linked, or attached to the other component, but, unless specifically stated otherwise, still another component may be interposed between the two components so that they are indirectly connected, coupled, linked, or attached.

It is also to be understood that when a component or layer is described as "being in contact with" or "overlapping" another component or layer, the component or layer may be in direct contact with or directly overlapping the other component or layer, but, unless specifically stated otherwise, still another component or layer may be interposed between these two components or layers so that they are in indirect contact with or indirectly overlapping each other.

The term "at least one" should be understood as including any and all combinations of one or more of the associated listed components. For example, the meaning of "at least one of a first component, a second component, and a third component" denotes any combination of two or more of the first component, the second component, and the third component as well as any of the first component, the second component, or the third component.

The terms "first direction," "second direction," "third direction," "row direction", "column direction", "X-axis direction," "Y-axis direction," and "Z-axis direction" should not be interpreted as referring only to geometrical relationships that are perpendicular to each other, but may indicate a broader range of directions within the functional scope of the configuration described in the present specification.

Features of various embodiments of the present specification may be partially or fully coupled or combined with each other, and technically, various types of interconnection and driving are possible. The embodiments of the present specification may be implemented independently of each other, or may be implemented together in a related relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

A display device according to the present disclosure may be implemented as a light emitting display device or a quantum dot display (QDD) device. Hereinafter, for convenience of description, a light emitting display device self-emitting light based on an inorganic light emitting diode or an organic light emitting diode will be described for example, but the present disclosure is not limited thereto, and other various types of display device may also be similarly applied.

In the present disclosure, a pixel circuit and a gate driver formed on a display panel may include a plurality of transistors. The transistors may be implemented with oxide thin film transistors (oxide TFTs) including an oxide semiconductor, low temperature polysilicon (LTPS) TFTs including low temperature polysilicon, and the like.

Moreover, a thin film transistor (TFT) described below may be implemented with an n-type TFT, a p-type TFT, or a combination of an n-type TFT and a p-type TFT. A TFT may be a three-electrode element including a gate, a source, and a drain. The source may be an electrode which provides a carrier to a transistor. In the TFT, a carrier may start to flow from the source. The drain may be an electrode where the carrier flows from the TFT to the outside. For example, in the TFT, the carrier flows from the source to the drain.

In the p-type TFT, because a carrier is a hole, a source voltage may be higher than a drain voltage so that the hole flows from the source to the drain. In the p-type TFT, because the hole flows from the source to the drain, a current may flow from the source to the drain. On the other hand, in the n-type TFT, because a carrier is an electron, a source voltage may be lower than a drain voltage so that the electron flows from the source to the drain. In the n-type TFT, because the electron flows from the source to the drain, a current may flow from the drain to the source. However, a source and a drain of a TFT may switch therebetween based on a voltage applied thereto. Based thereon, in the following description, one of a source and a drain will be described as a first electrode, and the other of the source and the drain will be described as a second electrode. However, since the source electrode and the drain electrode can be changed according to an applied voltage, the source electrode and the drain electrode of the transistor are not fixed.

Hereinafter, various example embodiments of the present specification will be described in detail with reference to the accompanying drawings. Further, all the components of each display device according to all embodiments of the present disclosure are operatively coupled and configured.

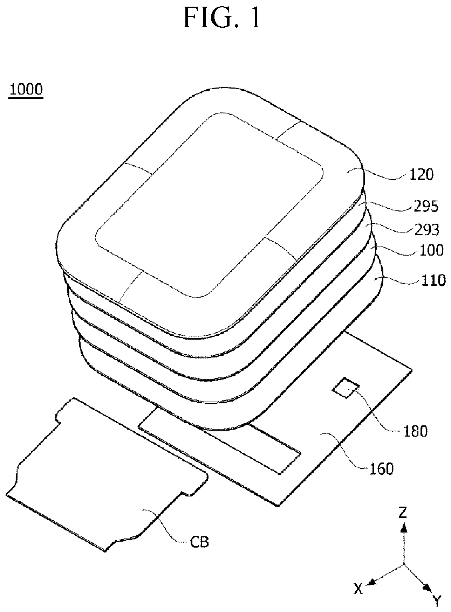

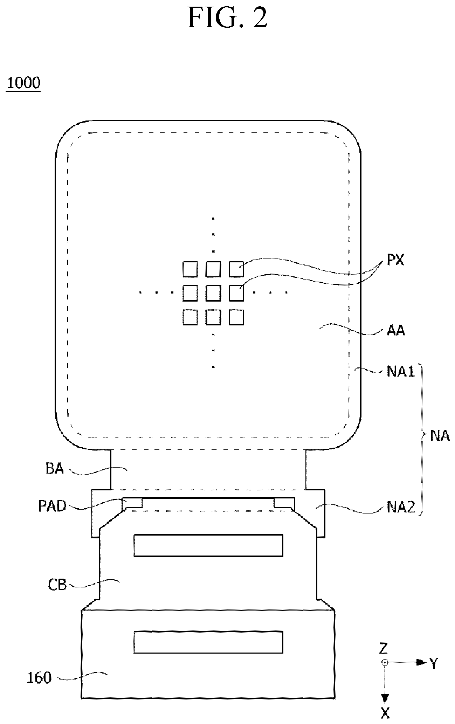

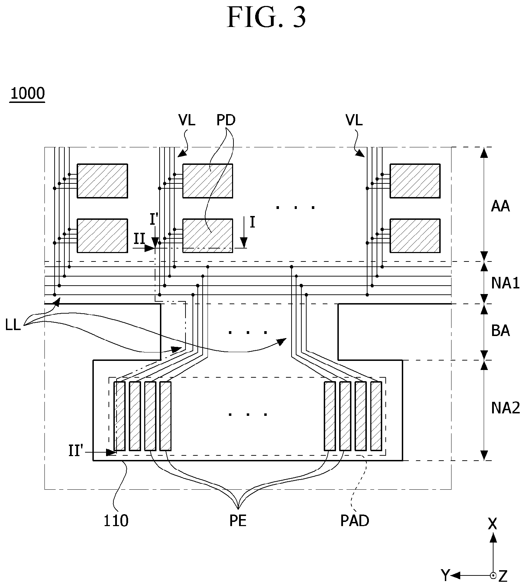

FIG. 1 is an exploded perspective view illustrating a display device according to an embodiment of the present specification. FIG. 2 is a plan view of the display device according to the embodiment of the present specification. FIG. 3 is an enlarged view of the display device according to the embodiment of the present specification.

Referring to FIGS. 1 to 3, a display device 1000 according to an embodiment of the present specification may include one or more of a display panel 100, a polarizing layer 293, an adhesive layer 295, a cover member 120, a substrate (or support substrate) 110, a flexible circuit board CB, and a printed circuit board 160. However, the present disclosure is not limited thereto, and more or less components may be included in the display device of the present disclosure. For example, various other function layers such as a diffusion layer, a reflective layer may also be disposed on the display device 100.

For example, the display device 1000 may include a substrate 110. The substrate 110 may be a member that supports other components of the display device 1000. The substrate 110 may be formed of an insulating material. For example, the substrate 110 may be formed of glass, resin, or the like. In addition, the substrate 110 may be formed of a material that has flexibility. For example, the substrate 110 may be formed of a plastic material having flexibility, such as any one of polyethylene terephthalate(PET), polycarbonate(PC), acrylonitrile-butadiene-styrene copolymer(ABS), polymethyl methacrylate(PMMA), polyethylene naphthalate(PEN), polyether sulfone(PES), cyclic olefin copolymer(COC), triacetylcellulose(TAC), polyvinyl alcohol(PVA), polyimide(PI), and polystyrene(PS). However, the embodiments of the present specification are not limited thereto.

The display panel 100 may implement information, videos, and/or images provided to a user. For example, the display panel 100 may include a display area AA and a non-display area NA adjacent to the display area AA. For example, the substrate 110 may include the display area AA and the non-display area NA. The display area AA and the non-display area NA are not limited to the substrate 110 but may be provided throughout the entire display device 1000.

The display area AA may be an area in which an image is displayed. The display area AA may include a plurality of pixels PX. Each of the plurality of pixels PX may include a plurality of sub-pixels. A plurality of light-emitting elements may be disposed in each of the plurality of sub-pixels. The plurality of light-emitting elements may be configured differently depending on the type of the display device 1000. For example, when the display device 1000 is an inorganic light-emitting display device, the light-emitting element may be a light-emitting diode (LED), a micro light-emitting diode (micro LED), or a mini light-emitting diode (mini LED), but the embodiments of the present specification are not limited thereto. The micro LED may be a light-emitting element having a size of 100 µm or less, but the present specification is not necessarily limited thereto.

The non-display area NA may be an area in which an image is not displayed. Various lines, circuits, and the like for driving the plurality of pixels PX of the display area AA may be disposed in the non-display area NA. For example, in the non-display area NA, various lines and driving circuits may be mounted, and a pad part PAD to which an integrated circuit, a printed circuit, or the like is connected may be disposed, but the embodiments of the present specification are not limited thereto.

For example, the driving circuits may be data driving circuits and/or gate driving circuits, but the embodiments of the present specification are not limited thereto. Lines through which control signals for controlling the driving circuits are supplied may be disposed on the display panel 100. For example, the control signals may include various timing signals such as clock signals, input data enable signals, and synchronization signals, but the embodiments of the present specification are not limited thereto. The control signals may be received through the pad part PAD. For example, link lines LL for transmitting signals may be disposed in the non-display area NA. For example, driving components such as the flexible circuit board CB and the printed circuit board 160 may be connected to the pad part PAD.

According to the present specification, the non-display area NA may include a first non-display area NA1, a bending area BA, and a second non-display area NA2. For example, the first non-display area NA1 may be an area surrounding at least a portion of the display area AA. The bending area BA may be an area extending from at least one of a plurality of sides of the first non-display area NA1, and may be a bendable area. The second non-display area NA2 may be an area extending from the bending area BA, and the pad part PAD may be disposed therein. For example, the bending area BA may be in a bent state, and the remaining area of the substrate 110, excluding the bending area BA, may be in a flat state. In this case, as the bending area BA is bent, the second non-display area NA2 may be located on a rear surface of the display area AA. However, the embodiments of the present specification are not limited thereto.

The display area AA of the substrate 110 or the display device 1000 may be configured in various shapes depending on the design of the display device 1000. For example, the display area AA may be configured in a rectangular shape with four rounded corners, but the embodiments of the present specification are not limited thereto. For another example, the display area AA may be configured in a rectangular shape with four right-angled corners, a circular shape, or the like, but the embodiments of the present specification are not limited thereto.

According to the present specification, a width of the second non-display area NA2, in which a plurality of pad electrodes PE are disposed, may be greater than a width of the bending area BA, in which only the plurality of link lines LL are disposed. In addition, a width of the display area AA in which the plurality of sub-pixels are disposed may be greater than the width of the bending area BA in which only the plurality of link lines LL are disposed. In the drawings, the width of the bending area BA is illustrated as being less than that of each of the other areas of the substrate 110, but the shape of the substrate 110 including the bending area BA is exemplary, and the embodiments of the present specification are not limited thereto.

Referring to FIG. 3, a plurality of pixel driving circuits PD may be disposed in the display area AA. The plurality of pixel driving circuits PD may be circuits for driving the light-emitting elements of the plurality of sub-pixels. Each of the plurality of pixel driving circuits PD includes a plurality of transistors including driving transistors, a storage capacitor, and the like, and the pixel driving circuits PD may supply control signals, power, and driving current to the light-emitting elements of the plurality of sub-pixels, thereby controlling the light-emission operations of the plurality of light-emitting elements. For example, the pixel driving circuit PD may include power lines and signal lines for controlling an on/off state and/or a light-emission time of the light-emitting element. For example, the plurality of pixel driving circuits PD may be drivers fabricated using a metal-oxide-silicon field-effect transistor (MOSFET) manufacturing process on a semiconductor substrate, but the embodiments of the present specification are not limited thereto. The drivers include the plurality of pixel driving circuits PD, and may drive the plurality of sub-pixels.

Referring to FIG. 1 together, the flexible circuit board (also referred to as flexible printed circuit or flexible film) CB and the printed circuit board 160 may be disposed below the display panel 100. The flexible circuit board CB and the printed circuit board 160 may be disposed at at least one side edge of the display panel 100, but the embodiments of the present specification are not limited thereto. One side of the flexible circuit board CB may be attached to the display panel 100, and the other side thereof may be attached to the printed circuit board 160, but the embodiments of the present specification are not limited thereto. The flexible circuit board CB may be a flexible film, but the embodiments of the present specification are not limited thereto.

The pad part PAD including the plurality of pad electrodes PE may be disposed in the second non-display area NA2. The driving components including one or more flexible circuit boards (or flexible films) CB and the printed circuit board 160 may be attached or bonded to the pad part PAD. The plurality of pad electrodes PE of the pad part PAD are electrically connected to one or more flexible circuit boards (or flexible films) CB and may transmit various signals (or power) output from the printed circuit board 160 and the flexible circuit boards (or flexible films) CB to the plurality of pixel driving circuits PD in the display area AA.

The flexible circuit board (or flexible film) CB may be a film in which various components are disposed on a base film having flexibility. For example, a driving integrated circuit (IC) such as a gate driver IC or a data driver IC may be disposed on the flexible circuit board (or flexible film) CB, but the embodiments of the present specification are not limited thereto. The driving IC may be a component that processes data and driving signals for displaying images. The driving IC may be disposed using methods such as chip on glass (COG), chip on film (COF), or tape carrier package (TCP) depending on a mounting method, but the embodiments of the present specification are not limited thereto. The flexible circuit board (or flexible film) CB may be attached or bonded onto the plurality of pad electrodes PE through a conductive adhesive layer, but the embodiments of the present specification are not limited thereto.

The printed circuit board 160 may be a component that is electrically connected to one or more flexible circuit boards (or flexible films) CB and supplies signals to the driving IC. The printed circuit board 160 may be disposed on one side of the flexible circuit board (or flexible film) CB, and may be electrically connected to the flexible circuit board (or flexible film) CB. Various components for supplying various signals to the driving IC may be disposed on the printed circuit board 160. For example, various components such as a timing controller, a power supply part, a memory, or a processor may be disposed on the printed circuit board 160. For example, the printed circuit board 160 may include a power management integrated circuit (PMIC), but the embodiments of the present specification are not limited thereto.

The printed circuit board 160 may include at least one hole 180, but the embodiments of the present specification are not limited thereto. An internal component configured to detect ambient light or temperature, which may be provided to a plurality of sensors, may be disposed in an area corresponding to the at least one hole 180. For example, the internal component may include an ambient light sensor (ALS), a temperature sensor, or the like, but the embodiments of the present specification are not limited thereto. For example, the hole 180 may be a through hole or the like, but the embodiments of the present specification are not limited thereto. In another example, the hole 180 may be a transmission region or hole, but the example embodiments of the present disclosure are not limited thereto.

Referring to FIG. 1, the polarizing layer 293 may be disposed on the display panel 100. The polarizing layer 293 may prevent or reduce the light generated from an external light source from entering the display panel 100 and affecting the light-emitting elements or the like.

The cover member 120 may be disposed on the polarizing layer 293. The cover member 120 may be a member for protecting the display panel 100. The adhesive layer 295 may be disposed between the polarizing layer 293 and the cover member 120. The cover member 120 may be attached to the display panel 100 by the adhesive layer 295. The adhesive layer 295 may include an optically clear adhesive (OCA), an optically clear resin (OCR), a pressure-sensitive adhesive (PSA), or the like, but the embodiments of the present specification are not limited thereto.

The substrate 110 may be disposed between the display panel 100 and the printed circuit board 160. The substrate 110 may reinforce the rigidity of the display panel 100. The substrate 110 may be a back plate, but the embodiments of the present specification are not limited thereto.

Referring to FIGS. 1 to 3, a plurality of link lines LL may be disposed in the non-display area NA. The plurality of link lines LL may be lines that transmit various signals supplied from one or more flexible circuit boards (or flexible films) CB and the printed circuit board 160 to the display area AA. The plurality of link lines LL may extend from the plurality of pad electrodes PE in the second non-display area NA2 toward the bending area BA and the first non-display area NA1 and may be electrically connected to a plurality of driving lines VL in the display area AA. The plurality of pixel driving circuits PD may be driven by receiving signals from one or more flexible circuit boards (or flexible films) CB and the printed circuit board 160 through the driving lines VL in the display area AA and the link lines LL in the non-display area NA.

For example, the plurality of driving lines VL, along with the plurality of link lines LL, may serve as lines for transmitting signals output from the flexible circuit board (or flexible film) CB and the printed circuit board 160 to the plurality of pixel driving circuits PD. The plurality of driving lines VL may be disposed in the display area AA and electrically connected to the plurality of pixel driving circuits PD, respectively. The plurality of driving lines VL may extend from the display area AA toward the non-display area NA to be electrically connected to the plurality of link lines LL. Accordingly, the signals output from the flexible circuit board (or flexible film) CB and the printed circuit board 160 may be transmitted to each of the plurality of pixel driving circuits PD through the plurality of link lines LL and the plurality of driving lines VL.

As the bending area BA is bent, some of the plurality of link lines LL may also be bent. Stress may be concentrated on a portion of the bent link lines LL, and as a result, cracks may occur in the link lines LL. Accordingly, the plurality of link lines LL may be formed of a conductive material with excellent flexibility to reduce cracks during the bending of the bending area BA. For example, the plurality of link lines LL may be formed of a conductive material with excellent flexibility such as gold (Au), silver (Ag), or aluminum (Al), but the embodiments of the present specification are not limited thereto. In addition, the plurality of link lines LL may be formed of one of various conductive materials used in the display area AA. For example, the plurality of link lines LL may be formed of molybdenum (Mo), chromium (Cr), titanium (Ti), nickel (Ni), neodymium (Nd), copper (Cu), an alloy of silver (Ag) and magnesium (Mg), or alloys thereof, but the embodiments of the present specification are not limited thereto. The plurality of link lines LL may be configured in a multilayer structure including various conductive materials. For example, the plurality of link lines LL may be configured in a triple-layer structure of titanium (Ti)/aluminum (Al)/titanium (Ti), but the embodiments of the present specification are not limited thereto.

The plurality of link lines LL may be configured in various shapes to reduce stress. At least some of the plurality of link lines LL disposed in the bending area BA may extend in the same direction as an extension direction of the bending area BA, or extend in a direction different from the extension direction of the bending area BA to reduce stress. For example, when the bending area BA extends in one direction from the first non-display area NA1 toward the second non-display area NA2, at least some of the link lines LL disposed in the bending area BA may extend in a direction oblique to the one direction. For another example, at least some of the plurality of link lines LL may be configured in various pattern shapes. For example, at least some of the plurality of link lines LL disposed in the bending area BA may have a conductive pattern repetitively disposed in at least one shape among a diamond shape, a rhombus shape, a trapezoidal wave shape, a triangular wave shape, a sawtooth wave shape, a sine wave shape, a circular shape, and an omega (Ω) shape, but the embodiments of the present specification are not limited thereto. Accordingly, to minimize or reduce the stress concentrated on the plurality of link lines LL and the resulting cracks, the plurality of link lines LL may be formed in various shapes including the above-described shapes, but the embodiments of the present specification are not limited thereto.

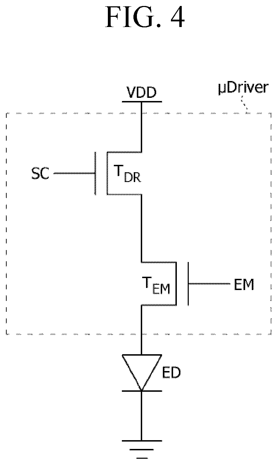

FIG. 4 is a diagram illustrating a circuit structure according to an embodiment of the present specification.

In FIG. 4, an example is illustrated in which one light-emitting element ED is connected to a driver µDriver, but the present specification is not limited thereto. For example, eight light-emitting elements ED may be connected to one driver µDriver. For another example, 16 light-emitting elements ED may be connected to one driver µDriver, or 32 light-emitting elements ED or 64 light-emitting elements ED may be simultaneously connected to one driver µDriver. The light-emitting element ED may be a micro light-emitting element (µLED). The driver µDriver may correspond to the pixel driving circuit PD or may include a plurality of pixel driving circuits PD integrated therein.

One driver µDriver may include a driving transistor T_{DR} and a light-emitting transistor T_{EM}, but the embodiments of the present specification are not limited thereto. For example, one or more other transistors and one or more capacitors may be included in the driver µDriver. For example, 2T1C, 3T1C, 4T1C, 5T1C, 3T2C, 4T2C, 5T2C, 6T2C, 7T1C, 7T2C, 8T1C, 8T2C structures, etc. are also possible for the driver µDriver.

For example, the driving transistor T_{DR} has a first electrode to which a high-potential power supply voltage VDD may be applied, a second electrode to which a first electrode of the light-emitting transistor T_{EM} may be connected, and a gate electrode to which a scan signal SC may be applied. The scan signal SC applied to the gate electrode of the driving transistor T_{DR} may be direct current (DC) power, and a fixed reference voltage Vref may be applied for each frame, but the embodiments of the present specification are not limited thereto.

The light-emitting transistor T_{EM} has the first electrode to which the second electrode of the driving transistor T_{DR} may be connected, a second electrode to which the light-emitting elements ED may be connected, and a gate electrode to which an emission signal EM may be applied. The emission signal EM applied to the gate electrode of the light-emitting transistor T_{EM} may be a pulse width modulation (PWM) signal that varies for each frame, but the embodiments of the present specification are not limited thereto.

A first electrode of the light-emitting element ED may be connected to the second electrode of the light-emitting transistor T_{EM}, and a second electrode of the light-emitting element ED may be connected to the ground. For example, the first electrode of the light-emitting element ED may be an anode, and the second electrode of the light-emitting element ED may be a cathode, but the embodiments of the present specification are not limited thereto.

The driving transistor T_{DR} and the light-emitting transistor T_{EM} may each be an n-type transistor or a p-type transistor.

In the driver µDriver, the driving transistor T_{DR} may be turned on by the scan signal SC applied from a timing controller (T-CON), and the light-emitting transistor T_{EM} may be turned on by the light-emission signal EM. As a result, a driving current may be applied to the light-emitting element ED via the driving transistor T_{DR} and the light-emitting transistor T_{EM} by the high-potential power supply voltage VDD applied to the first electrode of the driving transistor T_{DR}, thereby enabling the light-emitting element ED to emit light.

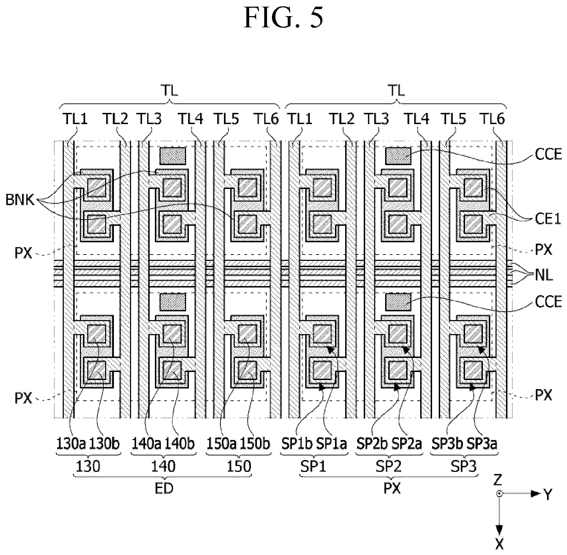

FIGS. 5 to 7 are plan views of a display device according to an embodiment of the present specification.

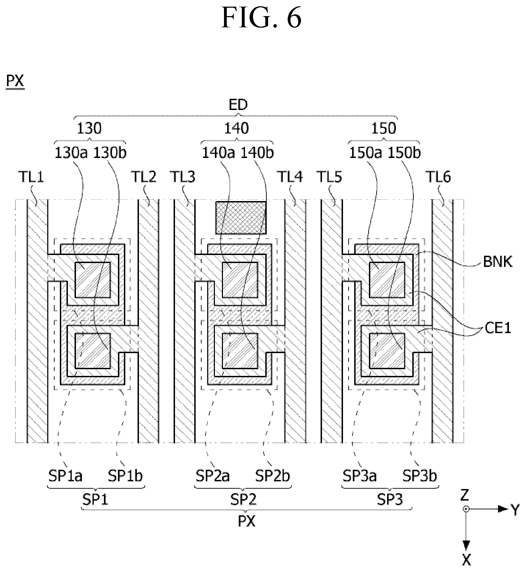

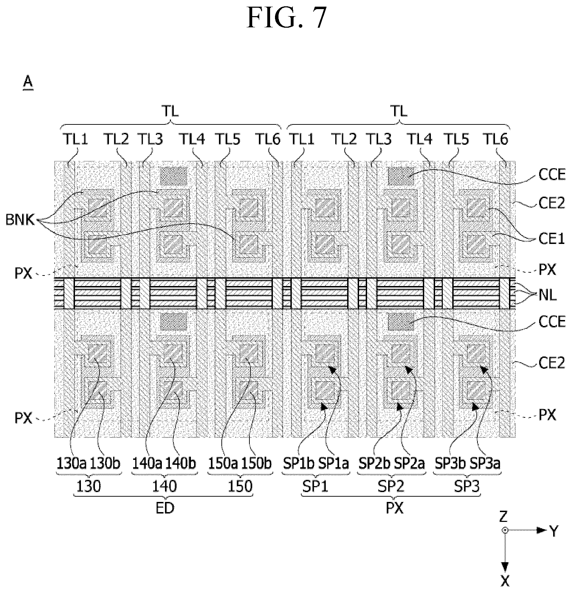

For example, FIG. 5 is an enlarged plan view of a display area including a plurality of pixels. For example, FIG. 6 is an enlarged plan view of the display area including one pixel. For example, FIG. 7 is an enlarged plan view of the display area including the plurality of pixels.

FIGS. 5 and 6 illustrate only a plurality of signal lines TL, a plurality of communication lines NL, a plurality of first driving electrodes CE1, a plurality of banks BNK, and a plurality of light-emitting elements ED, but the embodiments of the present specification are not limited thereto. FIG. 7 is an enlarged plan view of the display area of FIG. 5, in which a plurality of second electrodes CE2 are additionally disposed.

Referring to FIGS. 5 and 6, a plurality of pixels PX, each including a plurality of sub-pixels, may be disposed in the display area AA. Each of the plurality of sub-pixels includes a light-emitting element ED and may emit light independently. The plurality of sub-pixels may be disposed in a matrix form forming a plurality of rows and a plurality of columns, but the embodiments of the present specification are not limited thereto.

The plurality of sub-pixels may include a first sub-pixel SP1, a second sub-pixel SP2, and a third sub-pixel SP3. For example, one of the first sub-pixel SP1, the second sub-pixel SP2, and the third sub-pixel SP3 may be a red sub-pixel, another one thereof may be a green sub-pixel, and the remaining one thereof may be a blue sub-pixel. The types of the plurality of sub-pixels are exemplary, and the embodiments of the present specification are not limited thereto.

Each of the plurality of pixels PX may include one or more first sub-pixels SP1, one or more second sub-pixels SP2, and one or more third sub-pixels SP3. For example, one pixel PX may include a pair of first sub-pixels SP1, a pair of second sub-pixels SP2, and a pair of third sub-pixels SP3. The pair of first sub-pixels SP1 may include a 1-1 sub-pixel SP1a and a 1-2 sub-pixel SP1b. The pair of second sub-pixels SP2 may include a 2-1 sub-pixel SP2a and a 2-2 sub-pixel SP2b. The pair of third sub-pixels SP3 may include a 3-1 sub-pixel SP3a and a 3-2 sub-pixel SP3b. For example, one pixel PX may include the 1-1 sub-pixel SP1a and the 1-2 sub-pixel SP1b, the 2-1 sub-pixel SP2a and the 2-2 sub-pixel SP2b, and the 3-1 sub-pixel SP3a and the 3-2 sub-pixel SP3b, but the embodiments of the present specification are not limited thereto.

The plurality of sub-pixels constituting one pixel PX may be arranged in various ways. For example, in one pixel PX, the pair of first sub-pixels SP1 may be disposed in the same column, the pair of second sub-pixels SP2 may be disposed in the same column, and the pair of third sub-pixels SP3 may be disposed in the same column. The first sub-pixel SP1, the second sub-pixel SP2, and the third sub-pixel SP3 may be disposed in the same row. The number and arrangement of the plurality of sub-pixels constituting one pixel PX are exemplary, and the embodiments of the present specification are not limited thereto.

The plurality of signal lines TL may be disposed in areas between the plurality of sub-pixels. The plurality of signal lines TL may extend in a column direction between the plurality of sub-pixels. The plurality of signal lines TL may be lines that transmit an anode voltage output from the pixel driving circuit PD to the plurality of sub-pixels. For example, the plurality of signal lines TL may be electrically connected to the plurality of pixel driving circuits PD and the first driving electrodes CE1 of the plurality of sub-pixels. The anode voltage output from the pixel driving circuit PD may be transmitted to the first driving electrodes CE1 of the plurality of sub-pixels through the plurality of signal lines TL. For example, the first driving electrode CE1 may be an electrode that is electrically connected to an anode 134 of the light-emitting element ED. Thus, the anode voltage transmitted through the signal line TL may be transmitted to the anode 134 of the light-emitting element ED through the first driving electrode CE1.

Accordingly, the structure of the display device 1000 may be simplified by using the pixel driving circuit PD, in which a plurality of pixel circuits are integrated, instead of forming a plurality of transistors and a storage capacitor in each of the plurality of sub-pixels. In addition, as the circuits disposed in each of the plurality of sub-pixels are integrated into one pixel driving circuit PD, high-efficiency and low-power driving may be enabled.

The plurality of signal lines TL may include a first signal line TL1, a second signal line TL2, a third signal line TL3, a fourth signal line TL4, a fifth signal line TL5, and a sixth signal line TL6. The first signal line TL1 and the second signal line TL2 may be electrically connected to the pair of first sub-pixels SP1, respectively. The third signal line TL3 and the fourth signal line TL4 may be electrically connected to the pair of second sub-pixels SP2, respectively. The fifth signal line TL5 and the sixth signal line TL6 may be electrically connected to the pair of third sub-pixels SP3, respectively.

The first signal line TL1 may be disposed on one side of the pair of first sub-pixels SP1, and the second signal line TL2 may be disposed on the other side of the pair of first sub-pixels SP1. The first signal line TL1 may be electrically connected to the first driving electrode CE1 of one of the pair of first sub-pixels SP1, for example, the 1-1 sub-pixel SP1a. The second signal line TL2 may be electrically connected to the first driving electrode CE1 of the other of the pair of first sub-pixels SP1, for example, the 1-2 sub-pixel SP1b.

The third signal line TL3 may be disposed on one side of the pair of second sub-pixels SP2, and the fourth signal line TL4 may be disposed on the other side of the pair of second sub-pixels SP2. For example, the third signal line TL3 may be disposed adjacent to the second signal line TL2. The third signal line TL3 may be electrically connected to the first driving electrode CE1 of one of the pair of second sub-pixels SP2, for example, the 2-1 sub-pixel SP2a. The fourth signal line TL4 may be electrically connected to the first driving electrode CE1 of the other of the pair of second sub-pixels SP2, for example, the 2-2 sub-pixel SP2b.

The fifth signal line TL5 may be disposed on one side of the pair of third sub-pixels SP3, and the sixth signal line TL6 may be disposed on the other side of the pair of third sub-pixels SP3. For example, the fifth signal line TL5 may be disposed adjacent to the fourth signal line TL4. The sixth signal line TL6 may be disposed adjacent to the first signal line TL1 connected to the neighboring pixel PX. The fifth signal line TL5 may be electrically connected to the first driving electrode CE1 of one of the pair of third sub-pixels SP3, for example, the 3-1 sub-pixel SP3a. The sixth signal line TL6 may be electrically connected to the first driving electrode CE1 of the other of the pair of third sub-pixels SP3, for example, the 3-2 sub-pixel SP3b.

The plurality of signal lines TL may be formed of a conductive material. For example, the plurality of signal lines TL may be formed of a conductive material such as titanium (Ti), aluminum (Al), copper (Cu), molybdenum (Mo), nickel (Ni), chromium (Cr), indium tin oxide (ITO), indium zinc oxide (IZO), or indium gallium zinc oxide (IGZO), but the embodiments of the present specification are not limited thereto. For another example, the plurality of signal lines TL may be formed in a multilayer structure of conductive materials. For example, the plurality of signal lines TL may be formed in a multilayer structure of titanium (Ti)/aluminum (Al)/titanium (Ti)/indium tin oxide (ITO), but the embodiments of the present specification are not limited thereto.

The plurality of communication lines NL may be disposed in areas between the plurality of pixels PX. The plurality of communication lines NL may be disposed to extend in a row direction in the areas between the plurality of pixels PX. The plurality of communication lines NL are disposed in areas between the plurality of second electrodes CE2 and may not overlap the plurality of second electrodes CE2. For example, the plurality of communication lines NL may be lines used for short circuit-range communication, such as near-field communication (NFC). The plurality of communication lines NL may function as antennas. For example, the plurality of communication lines NL may be a plurality of connection lines or the like, but the embodiments of the present specification are not limited thereto.

According to the present specification, a bank BNK may be disposed in each of the plurality of sub-pixels. The plurality of banks BNK may be structures on which the plurality of light-emitting elements ED are mounted. The banks BNK of each of the plurality of sub-pixels SP may be configured to be separated from each other. For example, the banks BNK of each of the plurality of sub-pixels SP may be formed as an island shape. The plurality of banks BNK may guide the positions of the plurality of light-emitting elements ED in a transfer process of transferring the plurality of light-emitting elements ED to the display device 1000. Accordingly, the banks BNK of the first sub-pixel, the second sub-pixel, and the third sub-pixel to which different types of light-emitting elements ED are transferred can be easily identified.

In the transfer process of the plurality of light-emitting elements ED, the plurality of light-emitting elements ED may be transferred onto the plurality of banks BNK. The plurality of banks BNKs may be bank patterns or structures, but the embodiments of the present specification are not limited thereto.

A bank BNK of the first sub-pixel SP1, a bank BNK of the second sub-pixel SP2, and a bank BNK of the third sub-pixel SP3 may be disposed to be spaced apart from each other. The bank BNK of the first sub-pixel SP1, the bank BNK of the second sub-pixel SP2, and the bank BNK of the third sub-pixel SP3 may be configured to be separated from each other. Thus, the banks BNK of the first sub-pixel SP1, the second sub-pixel SP2, and the third sub-pixel SP3, onto which different types of light-emitting elements ED are transferred, may be easily identified.

A bank BNK of the 1-1 sub-pixel SP1a and a bank BNK of the 1-2 sub-pixel SP1b may be connected to each other, or may be spaced apart from each other or separately formed. For example, considering the design requirements of the transfer process and the like, the bank BNK of the 1-1 sub-pixel SP1a and the bank BNK of the 1-2 sub-pixel SP1b, in which the same type of light-emitting elements ED are disposed, may be connected to each other, or may be spaced apart or separated from each other. In addition, a bank BNK of the 2-1 sub-pixel SP2a and a bank BNK of the 2-2 sub-pixel SP2b may be connected to each other, or may be spaced apart from each other or separately formed. A bank BNK of the 3-1 sub-pixel SP3a and a bank BNK of the 3-2 sub-pixel SP3b may be connected to each other, or may be spaced apart from each other or separately formed. Accordingly, the banks BNK of the pair of first sub-pixels SP1, the banks BNK of the pair of second sub-pixels SP2, and the banks BNK of the pair of third sub-pixels SP3 may be variously formed, but the embodiments of the present specification are not limited thereto.

For example, the plurality of banks BNK may be formed of an organic insulating material. The plurality of banks BNK may be formed of a single layer or multiple layers of an organic insulating material. For example, the plurality of banks BNK may be formed of a photoresist, a polyimide (PI)-based material, or an acrylic-based material, but the embodiments of the present specification are not limited thereto.

The first driving electrode CE1 may be disposed in each of the plurality of sub-pixels. The first driving electrode CE1 may be disposed on the bank BNK. The first driving electrode CE1 may be electrically connected to one of the plurality of signal lines TL. At least a portion of the first driving electrode CE1 may extend outward from the bank BNK to be electrically connected to the signal line TL closest to the first driving electrode CE1. For example, a portion of the first driving electrode CE1 of the 1-1 sub-pixel SP1a may extend to one side area of the 1-1 sub-pixel SP1a to be electrically connected to the first signal line TL1, and a portion of the first driving electrode CE1 of the 1-2 sub-pixel SP1b may extend to the other side area of the 1-2 sub-pixel SP1b to be electrically connected to the second signal line TL2. A portion of the first driving electrode CE1 of the 2-1 sub-pixel SP2a may extend to one side area of the 2-1 sub-pixel SP2a to be electrically connected to the third signal line TL3, and a portion of the first driving electrode CE1 of the 2-2 sub-pixel SP2b may extend to the other side area of the 2-2 sub-pixel SP2b to be electrically connected to the fourth signal line TL4. A portion of the first driving electrode CE1 of the 3-1 sub-pixel SP3a may extend to one side area of the 3-1 sub-pixel SP3a to be electrically connected to the fifth signal line TL5, and a portion of the first driving electrode CE1 of the 3-2 sub-pixel SP3b may extend to the other side area of the 3-2 sub-pixel SP3b to be electrically connected to the sixth signal line TL6.

The first driving electrode CE1 may be electrically connected to the anode 134 of the light-emitting element ED, and may transmit the anode voltage output from the pixel driving circuit PD to the light-emitting element ED through the signal line TL. Different voltages may be applied to the first driving electrode CE1 of each of the plurality of sub-pixels depending on the displayed image. For example, different voltages may be applied to the first driving electrode CE1 of each of the plurality of sub-pixels. Accordingly, the first driving electrode CE1 may be a pixel electrode, but the embodiments of the present specification are not limited thereto.

The first driving electrode CE1 may be formed of a conductive material. For example, the first driving electrodes CE1 may be configured integrally with the plurality of signal lines TL. For example, the first driving electrodes CE1 may be formed of the same conductive material as the plurality of signal lines TL, but the embodiments of the present specification are not limited thereto. For example, the first driving electrode CE1 may be formed of a conductive material such as titanium (Ti), aluminum (Al), copper (Cu), molybdenum (Mo), nickel (Ni), chromium (Cr), indium tin oxide (ITO), indium zinc oxide (IZO), or indium gallium zinc oxide (IGZO), but the embodiments of the present specification are not limited thereto. For another example, the first driving electrode CE1 may be formed in a multilayer structure of conductive materials. For example, the plurality of first driving electrodes CE1 may be formed in a multilayer structure of titanium (Ti)/aluminum (Al)/titanium (Ti)/indium tin oxide (ITO), but the embodiments of the present specification are not limited thereto.

The light-emitting element ED may be disposed in each of the plurality of sub-pixels. Each of the plurality of light-emitting elements ED may be either a light-emitting diode (LED) or a micro light-emitting diode (micro LED), but the embodiments of the present specification are not limited thereto. The plurality of light-emitting elements ED may be disposed on the banks BNK and the first driving electrodes CE1. The plurality of light-emitting elements ED may be disposed on the first driving electrodes CE1, and may be electrically connected to the first driving electrodes CE1. Thus, the light-emitting element ED may emit light by receiving the anode voltage from the pixel driving circuit PD through the signal line TL and the first driving electrode CE1.

The plurality of light-emitting elements ED may include a first light-emitting element 130, a second light-emitting element 140, and a third light-emitting element 150. The first light-emitting element 130 may be disposed in the first sub-pixel SP1. The second light-emitting element 140 may be disposed in the second sub-pixel SP2. The third light-emitting element 150 may be disposed in the third sub-pixel SP3. For example, one of the first light-emitting element 130, the second light-emitting element 140, and the third light-emitting element 150 may be a red light-emitting element, another one thereof may be a green light-emitting element, and the remaining one thereof may be a blue light-emitting element, but the embodiments of the present specification are not limited thereto. Accordingly, by combining red light, green light, and blue light emitted from the plurality of light-emitting elements ED, various colors of light including white may be implemented. The types of the plurality of light-emitting elements ED are exemplary, and the embodiments of the present specification are not limited thereto.

The first light-emitting element 130 may include a 1-1 light-emitting element 130a disposed in the 1-1 sub-pixel SP1a and a 1-2 light-emitting element 130b disposed in the 1-2 sub-pixel SP1b. The second light-emitting element 140 may include a 2-1 light-emitting element 140a disposed in the 2-1 sub-pixel SP2a and a 2-2 light-emitting element 140b disposed in the 2-2 sub-pixel SP2b. The third light-emitting element 150 may include a 3-1 light-emitting element 150a disposed in the 3-1 sub-pixel SP3a and a 3-2 light-emitting element 150b disposed in the 3-2 sub-pixel SP3b.

Referring to FIGS. 5 to 7 together, the second electrode CE2 may be disposed in each of the plurality of sub-pixels. The second electrode CE2 may be disposed on the light-emitting element ED. The second electrodes CE2 may be electrically connected to the pixel driving circuit PD through a plurality of contact electrodes CCE.

For example, the second electrode CE2 may be electrically connected to a cathode 135 of the light-emitting element ED, and may transmit a cathode voltage output from the pixel driving circuit PD to the light-emitting element ED. The same cathode voltage may be applied to the second electrode CE2 of each of the plurality of sub-pixels. For example, the same voltage may be applied to the second electrodes CE2 of the plurality of sub-pixels and the cathode 135 of the light-emitting element ED. Accordingly, the second electrode CE2 may be a common electrode, but the embodiments of the present specification are not limited thereto.

At least some of the plurality of sub-pixels may share the second electrode CE2. At least some of the second electrodes CE2 of the plurality of sub-pixels may be electrically connected to each other. Since the same voltage is applied to the second electrodes CE2, the second electrodes CE2 of at least some of the sub-pixels may be shared. For example, the second electrodes CE2 of at least some of the plurality of pixels PX disposed in the same row may be connected to each other. For example, one second electrode CE2 may be disposed in the plurality of pixels PX. One second electrode CE2 may be disposed for every n sub-pixels.

For example, some of the second electrodes CE2 of the plurality of sub-pixels may be spaced apart from each other or separately disposed. For example, the second electrodes CE2 connected to the pixels PX in an nth row and the second electrodes CE2 connected to the pixels PX in a (n+1)th row may be spaced apart from each other or separately disposed. For example, the plurality of second electrodes CE2 may be disposed to be spaced apart from each other with the plurality of communication lines NL extending in the row direction interposed therebetween. Accordingly, the number of sub-pixels may be greater than the number of second electrodes CE2. For another example, all of the second electrodes CE2 of the plurality of sub-pixels may be interconnected so that one second electrode CE2 is disposed on the substrate 110, but the embodiments of the present specification are not limited thereto.

The plurality of second electrodes CE2 may be formed of a transparent conductive material, but the embodiments of the present specification are not limited thereto. The plurality of second electrodes CE2 may be formed of a transparent conductive material so that light emitted from the light-emitting elements ED is directed upward through the second electrodes CE2. For example, the second electrode CE2 may be formed of a transparent conductive material such as indium tin oxide (ITO), indium zinc oxide (IZO), or indium gallium zinc oxide (IGZO), but the embodiments of the present specification are not limited thereto.

The plurality of contact electrodes CCE may be disposed on the substrate 110. For example, the plurality of contact electrodes CCE may be disposed to be spaced apart from the plurality of banks BNK and the plurality of signal lines TL. Each of the plurality of second electrodes CE2 may overlap at least one contact electrode CCE. For example, one second electrode CE2 may overlap the plurality of contact electrodes CCE.

For example, the plurality of contact electrodes CCE may be electrically connected to the plurality of second electrodes CE2. The plurality of contact electrodes CCE may be disposed between the substrate 110 and the plurality of second electrodes CE2, and may transmit the cathode voltage output from the pixel driving circuit PD to the second electrodes CE2.

When micro LEDs are used as the light-emitting elements ED, a plurality of micro LEDs may be fabricated on a wafer and transferred onto the substrate 110 of the display device 1000 to manufacture the display device 1000. During the process of transferring the plurality of light-emitting elements ED having a micro size from the wafer to the substrate 110, various defects may occur. For example, in some sub-pixels, a transfer defect may occur in which the light-emitting element ED is not transferred, and in other sub-pixels, a defect may occur in which the light-emitting element ED is transferred out of an intended position due to misalignment. In addition, although the transfer process proceeds normally, the transferred light-emitting element ED itself may be defective. Thus, in consideration of the defects that may occur during the transfer process of the plurality of light-emitting elements ED, the plurality of light-emitting elements ED of the same type may be transferred onto one sub-pixel. A lighting test may be performed on the plurality of light-emitting elements ED, and ultimately, one light-emitting element ED that is determined to be normal may be used.

For example, the 1-1 light-emitting element 130a and the 1-2 light-emitting element 130b may be transferred together onto one pixel PX, and may be inspected to determine whether there is a defect. When both the 1-1 light-emitting element 130a and the 1-2 light-emitting element 130b are determined to be normal, the 1-1 light-emitting element 130a may be used, and the 1-2 light-emitting element 130b may not be used. For another example, when the 1-2 light-emitting element 130b among the 1-1 light-emitting element 130a and the 1-2 light-emitting element 130b is determined to be normal, the 1-1 light-emitting element 130a may not be used, and the 1-2 light-emitting element 130b may be used. Accordingly, even when the plurality of light-emitting elements ED of the same type are transferred onto one pixel PX, ultimately, one light-emitting element ED may be used.

Thus, one of the pair of light-emitting elements ED may be a main (or primary) light-emitting element ED, and the other one thereof may be a redundancy light-emitting element ED. The redundancy light-emitting element ED may be a spare light-emitting element ED transferred in preparation for a defective main light-emitting element ED. In the event of a defective main light-emitting element ED, the redundancy light-emitting element ED may be used as a replacement. Accordingly, by transferring both the main light-emitting element ED and the redundancy light-emitting element ED onto one pixel PX, the degradation of display quality due to the failure of the main light-emitting element ED or the redundancy light-emitting element ED may be minimized or reduced.

For example, the 1-1 light-emitting element 130a, the 2-1 light-emitting element 140a, and the 3-1 light-emitting element 150a transferred onto one pixel PX may be used as main light-emitting elements ED, and the 1-2 light-emitting element 130b, the 2-2 light-emitting element 140b, and the 3-2 light-emitting element 150b transferred onto one pixel PX may be used as redundancy light-emitting elements ED.

The display panel 100 according to the present specification may include the first driving electrodes CE1 disposed below the light-emitting elements ED, and may improve light extraction efficiency by exposing a portion of a conductive layer having high reflectivity among a plurality of conductive layers disposed on the first driving electrodes CE1 through a process such as an etching process.

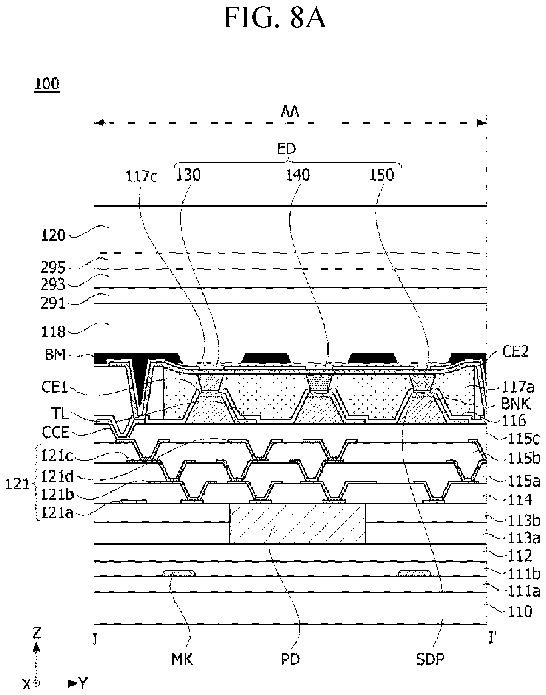

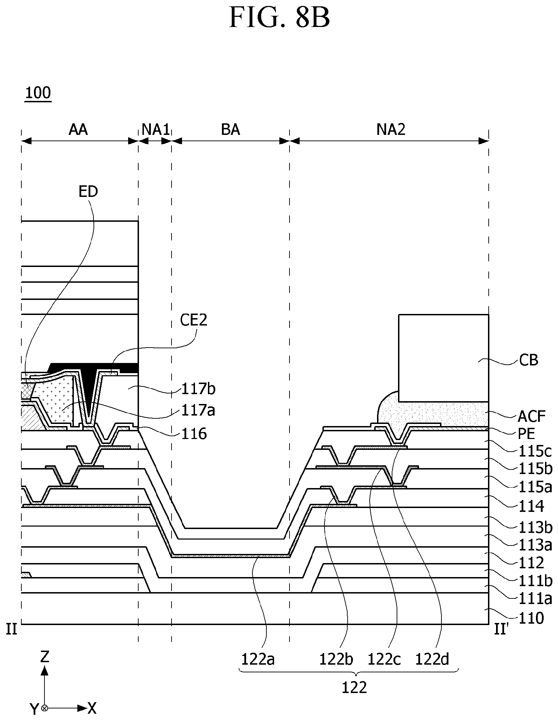

FIGS. 8A and 8B are cross-sectional views of the display device according to the embodiment of the present specification. For example, FIG. 8A is a cross-sectional view of the display area taken along line I-I' of FIG. 3, and FIG. 8B is a cross-sectional view of the first non-display area, the bending area, and the second non-display area taken along line II-II' of FIG. 3.

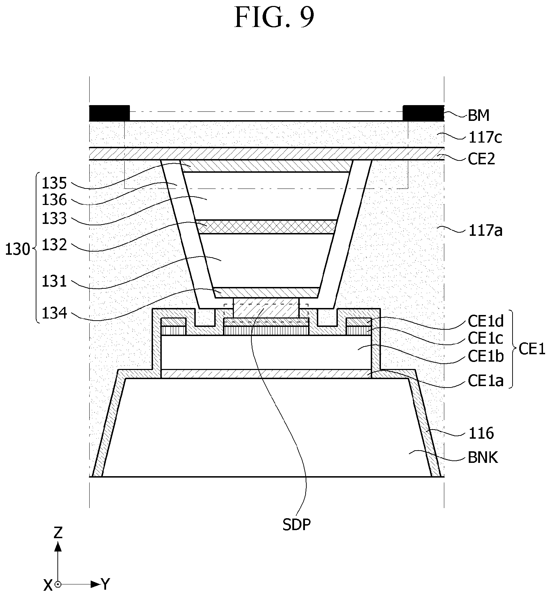

FIG. 9 is a cross-sectional view of the display device according to the embodiment of the present specification. For example, FIG. 9 is a cross-sectional view illustrating the sub-pixel including the light-emitting element disposed in the display area AA.

Referring to FIGS. 8A and 8B, a first buffer layer 111a and a second buffer layer 111b may be disposed in the remaining area of the substrate 110 excluding the bending area BA.

The first buffer layer 111a and the second buffer layer 111b may be disposed in the display area AA, the first non-display area NA1, and the second non-display area NA2. The first buffer layer 111a and the second buffer layer 111b may reduce the penetration of moisture or impurities through the substrate 110. The first buffer layer 111a and the second buffer layer 111b may be formed of an inorganic insulating material. For example, the first buffer layer 111a and the second buffer layer 111b may each be formed as a single layer or multiple layers of silicon oxide (SiOₓ) or silicon nitride (SiNₓ), but the embodiments of the present specification are not limited thereto.

For example, some of the first buffer layer 111a and the second buffer layer 111b located in the bending area BA may be removed. An upper surface of the substrate 110 located in the bending area BA may be exposed from the first buffer layer 111a and the second buffer layer 111b. The first buffer layer 111a and the second buffer layer 111b, which are formed of an inorganic insulating material, may be removed from the bending area BA to minimize or reduce cracks that may occur in the first buffer layer 111a and the second buffer layer 111b during bending.

A plurality of alignment keys MK may be disposed between the first buffer layer 111a and the second buffer layer 111b. The plurality of alignment keys MK may be configured to identify the position of the pixel driving circuit PD during the manufacturing process of the display device 1000. For example, the plurality of alignment keys MK may be configured to align the position of the pixel driving circuit PD that is transferred onto an adhesive layer 112. For another example, the plurality of alignment keys MK may be omitted.

The adhesive layer 112 may be disposed on the second buffer layer 111b. The adhesive layer 112 may be disposed in the display area AA, the first non-display area NA1, the bending area BA, and the second non-display area NA2. For another example, at least a portion of the adhesive layer 112 may be removed from the non-display area NA including the bending area BA. For example, the adhesive layer 112 may be formed of any one of an adhesive polymer, an epoxy resin, an ultraviolet (UV)-curable resin, a polyimide-based material, an acrylate-based material, a urethane-based material, and polydimethylsiloxane (PDMS), but the embodiments of the present specification are not limited thereto.

In the display area AA, the pixel driving circuit PD may be disposed on the adhesive layer 112. When the pixel driving circuit PD is implemented as a driver, the driver may be mounted on the adhesive layer 112 by a transfer process, but the embodiments of the present specification are not limited thereto.

A first protective layer 113a and a second protective layer 113b may be disposed on the adhesive layer 112 and the pixel driving circuit PD. The first protective layer 113a and the second protective layer 113b may be disposed to surround side surfaces of the pixel driving circuit PD, but the embodiments of the present specification are not limited thereto. For example, the second protective layer 113b may be disposed to cover at least a portion of an upper surface of the pixel driving circuit PD. For example, at least one of the first protective layer 113a and the second protective layer 113b disposed in the bending area BA may be omitted. For example, the first protective layer 113a may be entirely disposed in the display area AA and the non-display area NA, and the second protective layer 113b may be partially disposed in the display area AA, the first non-display area NA1, and the second non-display area NA2. For example, a portion of the second protective layer 113b in the bending area BA may be removed. However, the embodiments of the present specification are not limited thereto.

The first protective layer 113a and the second protective layer 113b may be formed of an organic insulating material, but the embodiments of the present specification are not limited thereto. For example, the first protective layer 113a and the second protective layer 113b may be formed of a photoresist, a polyimide (PI)-based material, a photo acrylic-based material, or the like, but the embodiments of the present specification are not limited thereto. For example, the first protective layer 113a and the second protective layer 113b may each be an overcoating layer or an insulating layer, but the embodiments of the present specification are not limited thereto.

According to the present specification, a plurality of first connection lines (or connection electrodes) 121 may be disposed on the second protective layer 113b in the display area AA. The plurality of first connection lines 121 may be lines for electrically connecting the pixel driving circuit PD to other components. For example, the pixel driving circuit PD may be electrically connected to the plurality of signal lines TL, the plurality of contact electrodes CCE, and the like through the plurality of first connection lines 121. For example, the plurality of first connection lines 121 may include a 1-1 connection line 121a, a 1-2 connection line 121b, a 1-3 connection line 121c, and a 1-4 connection line 121d, but the embodiments of the present specification are not limited thereto.

For example, a plurality of 1-1 connection lines 121a may be disposed on the second protective layer 113b. The plurality of 1-1 connection lines 121a may be electrically connected to the pixel driving circuit PD. The plurality of 1-1 connection lines 121a may transmit a voltage output from the pixel driving circuit PD to a first driving electrode CE1 or a second electrode CE2.

For example, a third protective layer 114 may be disposed on the second protective layer 113b. The third protective layer 114 may be entirely disposed in the display area AA and the non-display area NA. In the bending area BA, the third protective layer 114 may cover a side surface of the second protective layer 113b and an upper surface of the first protective layer 113a. The third protective layer 114 may be formed of an organic insulating material. For example, the third protective layer 114 may be formed of a photoresist, a polyimide (PI)-based material, a photo acrylic-based material, or the like, but the embodiments of the present specification are not limited thereto. For example, the first protective layer 113a, the second protective layer 113b, and the third protective layer 114 may be formed of the same material, but the embodiments of the present specification are not limited thereto.

A plurality of 1-2 connection lines 121b may be disposed on the third protective layer 114. The plurality of 1-2 connection lines 121b may be connected to or directly connected to the pixel driving circuit PD. For example, some of the 1-2 connection lines 121b may be directly connected to the pixel driving circuit PD through contact holes of the third protective layer 114. Another part of the 1-2 connection lines 121b may be electrically connected to the 1-1 connection line 121a through contact holes of the third protective layer 114. However, the embodiments of the present specification are not limited thereto. The voltage output from the pixel driving circuit PD may be transmitted to the first driving electrode CE1 or the second electrode CE2 through the plurality of 1-2 connection lines 121b and other connection lines.

A first insulating layer 115a may be disposed on the plurality of 1-2 connection lines 121b. The first insulating layer 115a may be entirely disposed in the display area AA and the non-display area NA, but the embodiments of the present specification are not limited thereto. The first insulating layer 115a may be formed of an organic insulating material, but the embodiments of the present specification are not limited thereto. For example, the first insulating layer 115a may be formed of a photoresist, a polyimide (PI)-based material, a photo acrylic-based material, or the like, but the embodiments of the present specification are not limited thereto.

A plurality of 1-3 connection lines 121c may be disposed on the first insulating layer 115a. The plurality of 1-3 connection lines 121c may be electrically connected to the plurality of 1-2 connection lines 121b. For example, the 1-3 connection lines 121c may be electrically connected to the 1-2 connection lines 121b through contact holes of the first insulating layer 115a.

A second insulating layer 115b may be disposed on the plurality of 1-3 connection lines 121c. The second insulating layer 115b may be disposed in the remaining area excluding the bending area BA, but the embodiments of the present specification are not limited thereto. The second insulating layer 115b may be disposed in the display area AA, the first non-display area NA1, and the second non-display area NA2, but the embodiments of the present specification are not limited thereto. For example, a portion of the second insulating layer 115b disposed in the bending area BA may be removed. The second insulating layer 115b may be formed of an organic insulating material, but the embodiments of the present specification are not limited thereto. For example, the second insulating layer 115b may be formed of a photoresist, a polyimide (PI)-based material, a photo acrylic-based material, or the like, but the embodiments of the present specification are not limited thereto.

A plurality of 1-4 connection lines 121d may be disposed on the second insulating layer 115b. The plurality of 1-4 connection lines 121d may be electrically connected to the plurality of 1-3 connection lines 121c. For example, the 1-4 connection lines 121d may be electrically connected to the 1-3 connection lines 121c through contact holes of the second insulating layer 115b.

According to the present specification, a plurality of second connection lines (or connection electrodes) 122 may be disposed on the second protective layer 113b in the non-display area NA. The plurality of second connection lines 122 may be lines for transmitting signals, which are transmitted from the flexible circuit board (or flexible film) CB and the printed circuit board 160 (see FIG. 1) to the pad part PAD, to the pixel driving circuit PD of the display area AA. For example, the plurality of second connection lines 122 may be electrically connected to the plurality of pad electrodes PE to receive the signals output from the flexible circuit board (or flexible film) CB and the printed circuit board.

For example, the plurality of second connection lines 122 may extend from the pad part PAD toward the display area AA and may transmit signals to the lines of the display area AA. In this case, the plurality of second connection lines 122 may function as the link lines LL. The plurality of second connection lines 122 may include a 2-1 connection line 122a, a 2-2 connection line 122b, a 2-3 connection line 122c, and a 2-4 connection line 122d.

A plurality of 2-1 connection lines 122a may be disposed on the second protective layer 113b. The plurality of 2-1 connection lines 122a may extend from the second non-display area NA2 to the bending area BA and the first non-display area NA1. The plurality of 2-1 connection lines 122a may transmit signals, which are transmitted to the pad part PAD from the flexible circuit board (or flexible film) CB and the printed circuit board, to the pixel driving circuit PD of the display area AA.

A plurality of 2-2 connection lines 122b may be disposed on the third protective layer 114. The plurality of 2-2 connection lines 122b may be disposed in the second non-display area NA2. The 2-2 connection lines 122b may be electrically connected to the 2-1 connection lines 122a through contact holes of the third protective layer 114. Accordingly, the signals output from the flexible circuit board (or flexible film) CB and the printed circuit board may be transmitted to the 2-1 connection lines 122a through the 2-2 connection lines 122b.

The 2-3 connection line 122c may be disposed on the first insulating layer 115a. The 2-3 connection line 122c may be disposed in the second non-display area NA2. The 2-3 connection line 122c may be electrically connected to the 2-2 connection line 122b through a contact hole of the first insulating layer 115a. Accordingly, the signals output from the flexible circuit board (or flexible film) CB and the printed circuit board may be transmitted to the 2-1 connection lines 122a through the 2-3 connection line 122c and the 2-2 connection lines 122b.

The 2-4 connection line 122d may be disposed on the second insulating layer 115b. The 2-4 connection line 122d may be disposed in the second non-display area NA2. The 2-4 connection line 122d may be electrically connected to the 2-3 connection line 122c through the contact hole of the second insulating layer 115b. Accordingly, the signals output from the flexible circuit board (or flexible film) CB and the printed circuit board may be transmitted to the 2-1 connection lines 122a through the 2-4 connection line 122d, the 2-3 connection line 122c, and the 2-2 connection lines 122b.

The plurality of first connection lines 121 and the plurality of second connection lines 122 may be formed of a highly flexible conductive material or any of the various conductive materials used in the display area AA. For example, the second connection lines 122, some of which are disposed in the bending area BA, may be formed of a highly flexible conductive material such as gold (Au), silver (Ag), or aluminum (Al), but the embodiments of the present specification are not limited thereto. For another example, the plurality of first connection lines 121 and the plurality of second connection lines 122 may be formed of molybdenum (Mo), chromium (Cr), titanium (Ti), nickel (Ni), neodymium (Nd), copper (Cu), an alloy of silver (Ag) and magnesium (Mg), alloys thereof, or the like, but the embodiments of the present specification are not limited thereto.

A third insulating layer 115c may be disposed on the plurality of first connection lines 121 and the plurality of second connection lines 122. The third insulating layer 115c may be disposed in the remaining area excluding the bending area BA, but the embodiments of the present specification are not limited thereto. The third insulating layer 115c may be disposed in the display area AA, the first non-display area NA1, and the second non-display area NA2. A portion of the third insulating layer 115c in the bending area BA may be removed. The third insulating layer 115c may be formed of an organic insulating material, but the embodiments of the present specification are not limited thereto. For example, the third insulating layer 115c may be formed of a photoresist, a polyimide (PI)-based material, a photo acrylic-based material, or the like, but the embodiments of the present specification are not limited thereto.

In the display area AA, a plurality of banks BNK may be disposed on the third insulating layer 115c. The plurality of banks BNK may be disposed to overlap the plurality of sub-pixels, respectively. At least one or more light-emitting elements ED of the same type may be disposed on each of the plurality of banks BNK.

The plurality of signal lines TL may be disposed on the third insulating layer 115c in the display area AA. The plurality of signal lines TL may be disposed in areas between the plurality of banks BNK. For example, each of the plurality of signal lines TL may be disposed adjacent to a respective one of the plurality of banks BNK.

The plurality of contact electrodes CCE may be disposed on the third insulating layer 115c in the display area AA. The plurality of contact electrodes CCE may supply a cathode voltage output from the pixel driving circuit PD to the second electrode CE2.

The first driving electrode CE1 may be disposed on the bank BNK. For example, the first driving electrode CE1 may be disposed to extend toward an upper portion of the bank BNK from the adjacent signal line TL. The first driving electrode CE1 may be disposed on upper and side surfaces of the bank BNK. For example, the first driving electrode CE1 may be disposed to extend from the signal line TL on an upper surface of the third insulating layer 115c to the side and upper surfaces of the bank BNK.

Referring to FIG. 9, the first driving electrode CE1 and the contact electrode CCE may each be configured with a plurality of conductive layers. The first driving electrode CE1 and the contact electrode CCE may be formed by the same process, and each of the first driving electrode CE1 and the first driving electrode CE1 may include the same plurality of conductive layers.

The first driving electrode CE1 may include a first conductive layer CE1a, a second conductive layer CE1b, a third conductive layer CE1c, and a fourth conductive layer CE1d, but the embodiments of the present specification are not limited thereto.

The first conductive layer CE1a may be disposed on the bank BNK. The second conductive layer CE1b may be disposed on the first conductive layer CE1a. The third conductive layer CE1c may be disposed on the second conductive layer CE1b. The fourth conductive layer CE1d may be disposed on the third conductive layer CE1c. For example, the first conductive layer CE1a, the second conductive layer CE1b, the third conductive layer CE1c, and the fourth conductive layer CE1d may each be formed of at least one of titanium (Ti), molybdenum (Mo), aluminum (Al), and indium tin oxide (ITO), but the embodiments of the present specification are not limited thereto.

According to the present specification, among the plurality of conductive layers forming the first driving electrode CE1, some conductive layers with high reflectivity may be configured as alignment keys and/or reflectors for the alignment of the light-emitting element ED. For example, among the plurality of conductive layers of the first driving electrode CE1, the second conductive layer CE1b may include a reflective material. For example, the second conductive layer CE1b may include aluminum (Al), but the embodiments of the present specification are not limited thereto. Accordingly, the second conductive layer CE1b may be configured as a reflector. Further, due to the high reflectivity of the second conductive layer CE1b, identification may be facilitated in the manufacturing process, thereby allowing the position or transfer position of the light-emitting element ED to be aligned based on the second conductive layer CE1b.

For example, to configure the second conductive layer CE1b as a reflector, the third conductive layer CE1c and the fourth conductive layer CE1d covering the second conductive layer CE1b may be partially removed or etched. For example, some of the third conductive layer CE1c and the fourth conductive layer CE1d may be removed or etched to expose an upper surface of the second conductive layer CE1b. For example, in each of the third conductive layer CE1c and the fourth conductive layer CE1d, a central portion on which the solder pattern SDP is disposed and edge portions may be retained, whereas the remaining portions may be removed. For example, the edge portions of each of the third conductive layer CE1c, which is formed of titanium (Ti), and the fourth conductive layer CE1d, which is formed of indium tin oxide (ITO), may not be etched. Accordingly, it is possible to prevent or obviate other conductive layers of the first driving electrode CE1, such as the second conductive layer CE1b, from being corroded by a tetramethylammonium hydroxide (TMAH) solution used in the masking process forming the first driving electrode CE1.

According to the present specification, the first conductive layer CE1a and the third conductive layer CE1c may include titanium (Ti) or molybdenum (Mo). The second conductive layer CE1b may include aluminum (Al). The fourth conductive layer CE1d may include a transparent conductive oxide layer, such as indium tin oxide (ITO) or indium zinc oxide (IZO), which has good adhesion to the solder pattern SDP and exhibits corrosion resistance and acid resistance. However, the embodiments of the present specification are not limited thereto.

The first conductive layer CE1a, the second conductive layer CE1b, the third conductive layer CE1c, and the fourth conductive layer CE1d may be sequentially deposited and then patterned through a photolithography process and an etching process, but the embodiments of the present specification are not limited thereto.

According to the present specification, the signal line TL, contact electrode CCE, and pad electrode PE, which are disposed on the same layer as the first driving electrode CE1, may be formed as multiple layers of conductive materials, but the embodiments of the present specification are not limited thereto. For example, the signal line TL, the contact electrode CCE, and the pad electrode PE may be formed as multiple layers of indium tin oxide (ITO)/titanium (Ti)/aluminum (Al)/titanium (Ti), but the embodiments of the present specification are not limited thereto.

According to the present specification, the solder pattern SDP may be disposed on the first driving electrode CE1 in each of the plurality of sub-pixels. The solder pattern SDP may allow the light-emitting element ED to be bonded to the first driving electrode CE1. The first driving electrode CE1 and the light-emitting element ED may be electrically connected through eutectic bonding using the solder pattern SDP, but the embodiments of the present specification are not limited thereto. For example, the first driving electrode CE1 and the anode 134 of the light-emitting element ED may be electrically connected through eutectic bonding using the solder pattern SDP, but the embodiments of the present specification are not limited thereto. For example, when the solder pattern SDP is formed of indium (In) and the anode 134 of the light-emitting element ED is formed of gold (Au), the solder pattern SDP and the anode 134 may be bonded by applying heat and pressure during the transfer process of the light-emitting element ED. Through eutectic bonding, the light-emitting element ED may be bonded to the solder pattern SDP and the first driving electrode CE1 without any additional adhesive. For example, the solder pattern SDP may be formed of indium (In), tin (Sn), or an alloy thereof, but the embodiments of the present specification are not limited thereto. For example, the solder pattern SDP may be a pattern layer, a pattern, a bonding pad, a joining pad, or the like, but the embodiments of the present specification are not limited thereto.

According to the present specification, a first passivation layer 116 may be disposed on the plurality of signal lines TL, the plurality of first driving electrodes CE1, the plurality of contact electrodes CCE, and the third insulating layer 115c. For example, the first passivation layer 116 may be disposed in the display area AA, the first non-display area NA1, and the second non-display area NA2. A portion of the first passivation layer 116 disposed in the bending area BA may be removed. In the second non-display area NA2, a portion of the first passivation layer 116 covering the plurality of pad electrodes PE may be removed. The first passivation layer 116 may be disposed to cover remaining areas except for the bending area BA, the area in which the plurality of pad electrodes PE and the solder pattern SDP are disposed, and a partial area of the contact electrode CCE that is exposed for connection to the second electrode CE2, thereby reducing the penetration of moisture or impurities into the light-emitting element ED. For example, the first passivation layer 116 may be formed as a single layer or multiple layers of silicon oxide (SiOₓ) or silicon nitride (SiNₓ), but the embodiments of the present specification are not limited thereto. For example, the first passivation layer 116 may be a protective layer, an insulating layer, or the like, but the embodiments of the present specification are not limited thereto. In addition, the first passivation layer 116 may be formed to have a thickness of 1000 to 2000 Å, which is smaller than a thickness of the second electrode CE2.

In each of the plurality of sub-pixels, the light-emitting element ED may be disposed on the solder pattern SDP. In the first sub-pixel SP1, the first light-emitting element 130 may be disposed. In the second sub-pixel SP2, the second light-emitting element 140 may be disposed. The third light-emitting element 150 disposed in the third sub-pixel SP3.

The light-emitting element ED may be formed on a silicon wafer using methods such as metal organic chemical vapor deposition (MOCVD), chemical vapor deposition (CVD), plasma-enhanced chemical vapor deposition (PECVD), molecular beam epitaxy (MBE), hydride vapor phase epitaxy (HVPE), or sputtering, but the embodiments of the present specification are not limited thereto.

The first light-emitting element 130 may include the anode 134, a light-emitting structure, the cathode 135, and an encapsulation film 136, but the embodiments of the present specification are not limited thereto. For example, the first light-emitting element 130 may not include the encapsulation film 136. The light-emitting structure may include a first semiconductor layer 131, an active layer 132, and a second semiconductor layer 133.

The first semiconductor layer 131 may be disposed on the solder pattern SDP. The second semiconductor layer 133 may be disposed on the first semiconductor layer 131.

For example, one of the first semiconductor layer 131 and the second semiconductor layer 133 may be implemented as a group III-V compound semiconductor, a group II-VI compound semiconductor, or the like and may be doped with impurities (or dopants). For example, one of the first semiconductor layer 131 and the second semiconductor layer 133 may be a semiconductor layer doped with n-type impurities, and the other may be a semiconductor layer doped with p-type impurities, but the embodiments of the present specification are not limited thereto. For example, one or more of the first semiconductor layer 131 and the second semiconductor layer 133 may be a layer doped with n-type or p-type impurities in a material such as gallium nitride (GaN), gallium phosphide (GaP), gallium arsenide phosphide (GaAsP), aluminum gallium indium phosphide (AlGaInP), indium aluminum phosphide (InAlP), aluminum gallium nitride (AlGaN), aluminum indium nitride (AllnN), aluminum indium gallium nitride (AllnGaN), aluminum gallium arsenide (AlGaAs), gallium arsenide (GaAs), or the like, but the embodiments of the present specification are not limited thereto. For example, the n-type impurities may include silicon (Si), germanium (Ge), selenium (Se), carbon (C), tellurium (Te), tin (Sn), and the like, but the embodiments of the present specification are not limited thereto. For example, the p-type impurities may include magnesium (Mg), zinc (Zn), calcium (Ca), strontium (Sr), barium (Ba), beryllium (Be), and the like, but the embodiments of the present specification are not limited thereto.

For example, the first semiconductor layer 131 and the second semiconductor layer 133 may be a nitride semiconductor containing n-type impurities and a nitride semiconductor containing p-type impurities, respectively, but the embodiments of the present specification are not limited thereto. For example, the first semiconductor layer 131 may be a nitride semiconductor containing p-type impurities, and the second semiconductor layer 133 may be a nitride semiconductor containing n-type impurities, but the embodiments of the present specification are not limited thereto.

The active layer 132 may be disposed between the first semiconductor layer 131 and the second semiconductor layer 133. The active layer 132 may emit light by receiving holes and electrons from the first semiconductor layer 131 and the second semiconductor layer 133. For example, the active layer 132 may include one of a single well structure, a multi-well structure, a single quantum well structure, a multi-quantum well (MQW) structure, a quantum dot structure, and a quantum wire structure, but the embodiments of the present specification are not limited thereto. For example, the active layer 132 may be formed of indium gallium nitride (InGaN), gallium nitride (GaN), or the like, but the embodiments of the present specification are not limited thereto.

For another example, the active layer 132 may include a multi-quantum well (MQW) structure having a well layer and a barrier layer with a higher bandgap than the well layer. For example, the active layer 132 may include an InGaN well layer and an AlGaN barrier layer, but the embodiments of the present specification are not limited thereto.

The anode 134 may be disposed between the first semiconductor layer 131 and the solder pattern SDP. For example, the anode 134 may electrically connect the first semiconductor layer 131 and the first driving electrode CE1. An anode voltage output from the pixel driving circuit PD may be applied to the first semiconductor layer 131 through the signal line TL, the first driving electrode CE1, and the anode 134. For example, the anode 134 may be formed of a conductive material capable of eutectic bonding with the solder pattern SDP, but the embodiments of the present specification are not limited thereto. For example, the anode 134 may be formed of gold (Au), tin (Sn), tungsten (W), silicon (Si), silver (Ag), titanium (Ti), iridium (Ir), chromium (Cr), indium (In), zinc (Zn), lead (Pb), nickel (Ni), platinum (Pt), copper (Cu), or an alloy thereof, but the embodiments of the present specification are not limited thereto.

The cathode 135 may be disposed on the second semiconductor layer 133. For example, the cathode 135 may electrically connect the second semiconductor layer 133 and the second electrode CE2. A cathode voltage output from the pixel driving circuit PD may be applied to the second semiconductor layer 133 through the contact electrode CCE, the second electrode CE2, and the cathode 135. The cathode 135 may be formed of a transparent conductive material to allow light emitted from the light-emitting element ED to be directed upward, but the embodiments of the present specification are not limited thereto. For example, the cathode 135 may be formed of a material such as indium tin oxide (ITO), indium zinc oxide (IZO), or indium gallium zinc oxide (IGZO), but the embodiments of the present specification are not limited thereto.

The encapsulation film 136 may be disposed on at least some of the first semiconductor layer 131, the active layer 132, the second semiconductor layer 133, the anode 134, and the cathode 135. For example, the encapsulation film 136 may surround at least some of the first semiconductor layer 131, the active layer 132, the second semiconductor layer 133, the anode 134, and the cathode 135.

For example, the encapsulation film 136 may protect the first semiconductor layer 131, the active layer 132, and the second semiconductor layer 133. For example, the encapsulation film 136 may be disposed on the side surfaces of the first semiconductor layer 131, the active layer 132, and the second semiconductor layer 133.

For example, the encapsulation film 136 may be disposed on at least a portion of each of the anode 134 and the cathode 135, for example, on an edge portion (or one side) of the anode 134 and an edge portion (or one side) of the cathode 135. At least a portion of the anode 134 may be exposed from the encapsulation film 136, thereby allowing the anode 134 to be connected to the solder pattern SDP. For example, at least a portion of the cathode 135 may be exposed from the encapsulation film 136, thereby allowing the cathode 135 to be connected to the second electrode CE2. For example, the encapsulation film 136 may be formed of an insulating material such as silicon nitride (SiNₓ) or silicon oxide (SiOₓ), but the embodiments of the present specification are not limited thereto.

For another example, the encapsulation film 136 may have a structure in which a reflective material is dispersed in a resin layer, but the embodiments of the present specification are not limited thereto. For example, the encapsulation film 136 may be fabricated as a reflector with various structures, but the embodiments of the present specification are not limited thereto. Light emitted from the active layer 132 may be reflected upward by the encapsulation film 136, thereby enhancing light extraction efficiency. For example, the encapsulation film 136 may be a reflective layer, but the embodiments of the present specification are not limited thereto.

According to the present specification, the light-emitting element ED has been described as having a vertical structure, but the embodiments of the present specification are not limited thereto. For example, the light-emitting element ED may have a lateral structure or a flip chip structure.

Although the first light-emitting element 130 has been described with reference to FIG. 9, but the second light-emitting element 140 and the third light-emitting element 150 may have substantially the same structure as the first light-emitting element 130. For example, the second light-emitting element 140 and the third light-emitting element 150 may have substantially the same structure as the first semiconductor layer 131, the active layer 132, the second semiconductor layer 133, the anode 134, the cathode 135, and the encapsulation film 136 of the first light-emitting element 130.

According to the present specification, first optical layers 117a surrounding the plurality of light-emitting elements ED may be disposed around the light-emitting elements ED in the display area AA. The first optical layers 117a may surround the plurality of light-emitting elements ED. For example, the first optical layers 117a may be disposed to cover the plurality of light-emitting elements ED and the banks BNK in the areas of the plurality of sub-pixels. For example, the first optical layers 117a may cover the banks BNK, a portion of the first passivation layer 116, and spaces between the plurality of light-emitting elements ED. The first optical layers 117a may be disposed or may cover the spaces between the plurality of light-emitting elements ED included in one pixel PX and between the plurality of banks BNK. For example, the first optical layers 117a may extend in a first direction (X-axis direction) and may be disposed spaced apart in a second direction (Y-axis direction). For example, the first optical layer 117a may be disposed to surround side portions of the light-emitting element ED and the bank BNK between the first passivation layer 116 and the second electrode CE2, but the embodiments of the present specification are not limited thereto. For example, the first optical layer 117a may be a diffusion layer, a sidewall diffusion layer, or the like, but the embodiments of the present specification are not limited thereto.

The first optical layer 117a may include an organic insulating material in which fine particles are dispersed, but the embodiments of the present specification are not limited thereto. For example, the first optical layer 117a may be formed of siloxane in which fine metal particles, such as titanium dioxide (TiO₂) particles, are dispersed, but the embodiments of the present specification are not limited thereto. Light emitted from the plurality of light-emitting elements ED may be scattered by the fine particles dispersed in the first optical layer 117a and emitted to the outside of the display device 1000. Accordingly, the first optical layer 117a may improve the extraction efficiency of the light emitted from the plurality of light-emitting elements ED.

For example, the first optical layer 117a may be disposed in each of the plurality of pixels PX, or the first optical layers 117a may be disposed together with some of the pixels PX disposed in the same row, but the embodiments of the present specification are not limited thereto. For example, the first optical layer 117a may be disposed in each of the plurality of pixels PX, or the plurality of pixels PX may share one first optical layer 117a. For another example, each of the plurality of sub-pixels may separately include the first optical layer 117a, but the embodiments of the present specification are not limited thereto.

According to the present specification, a second optical layer 117b may be disposed on the first passivation layer 116 in the display area AA. For example, the second optical layer 117b may be disposed around the first optical layer 117a. For example, the second optical layer 117b may be disposed to surround the first optical layer 117a. For example, the second optical layer 117b may be in contact with a side surface of the first optical layer 117a. For example, the second optical layer 117b may be disposed in the area between the plurality of pixels PX. However, the embodiments of the present specification are not limited thereto, and for example, the second optical layer 117b may be a diffusion layer, a diffusion layer window, a window diffusion layer, or the like, but the embodiments of the present specification are not limited thereto.

The second optical layer 117b may be formed of an organic insulating material, but the embodiments of the present specification are not limited thereto. The second optical layer 117b may be formed of the same material as the first optical layer 117a, but the embodiments of the present specification are not limited thereto. For example, the first optical layer 117a may include fine particles, and the second optical layer 117b may not include fine particles. For example, the second optical layer 117b may be formed of siloxane, but the embodiments of the present specification are not limited thereto.

For example, a thickness of the first optical layer 117a may be less than a thickness of the second optical layer 117b, but the embodiments of the present specification are not limited thereto. Accordingly, when viewed in a plan view, an area in which the first optical layer 117a is disposed may include a recessed portion that is recessed inward relative to an upper surface of the second optical layer 117b.

According to the present specification, the second electrode CE2 may be disposed on the first optical layer 117a and the second optical layer 117b. For example, the second electrode CE2 may be electrically connected to the plurality of contact electrodes CCE through contact holes of the second optical layer 117b. For example, the second electrode CE2 may be disposed on the plurality of light-emitting elements ED. For example, the second electrode CE2 may include a transparent conductive oxide such as indium tin oxide (ITO) or indium zinc oxide (IZO), but the embodiments of the present specification are not limited thereto. For example, the second electrode CE2 may be disposed to be in contact with the cathode 135. For example, the second electrode CE2 may overlap the first optical layer 117a. For example, the second electrode CE2 may cover an outer plane of the first optical layer 117a.

The second electrode CE2 may continuously extend in the first direction (X-axis direction) of the substrate 110. Accordingly, the second electrode CE2 may be commonly connected to the plurality of pixels PX arranged in the first direction X of the substrate 110. For example, the second electrode CE2 may be commonly connected to the plurality of pixels PX.

According to the present specification, the second electrode CE2 may continuously extend on the first optical layer 117a, the second optical layer 117b, and the light-emitting element ED. The area in which the first optical layer 117a is disposed may include a recessed portion that is recessed inward relative to the upper surface of the second optical layer 117b. Accordingly, since a first portion of the second electrode CE2 disposed on the first optical layer 117a is disposed along the recessed portion, the first portion of the second electrode CE2 may be disposed at a position lower than that of a second portion of the second electrode CE2 disposed on the second optical layer 117b.

A third optical layer 117c may be disposed on the second electrode CE2. The third optical layer 117c may be disposed to overlap the plurality of light-emitting elements ED and the first optical layer 117a. Since the third optical layer 117c is disposed on the second electrode CE2 and the plurality of light-emitting elements ED, the third optical layer 117c may improve mura that may occur in some of the plurality of light-emitting elements ED. For example, when transferring the plurality of light-emitting elements ED onto the substrate 110 of the display device 1000, an area in which intervals between the plurality of light-emitting elements ED are not uniform may occur due to process variations or the like. When the intervals between the plurality of light-emitting elements ED are not uniform, light emission areas of each of the plurality of light-emitting elements ED may be disposed unevenly, which may cause a user to perceive mura. Accordingly, by configuring the third optical layer 117c to uniformly diffuse light over the plurality of light-emitting elements ED, the occurrence of light emitted from some light-emitting elements ED appearing as mura can be reduced. Accordingly, the light emitted from the plurality of light-emitting elements ED is evenly diffused by the third optical layer 117c and extracted to the outside of the display device 1000, thereby improving luminance uniformity of the display device 1000.

The third optical layer 117c may be formed of an organic insulating material in which fine particles are dispersed, but the embodiments of the present specification are not limited thereto. For example, the third optical layer 117c may be formed of siloxane in which fine metal particles, such as titanium dioxide (TiO₂) particles, are dispersed, but the embodiments of the present specification are not limited thereto. For example, the third optical layer 117c may be formed of the same material as the first optical layer 117a, but the embodiments of the present specification are not limited thereto. For example, the third optical layer 117c may be a diffusion layer, an upper diffusion layer, or the like, but the embodiments of the present specification are not limited thereto.

According to the present specification, light emitted from the plurality of light-emitting elements ED may be scattered by the fine particles dispersed in the third optical layer 117c and emitted to the outside of the display device 1000. The third optical layer 117c may evenly mix the light emitted from the plurality of light-emitting elements ED, thereby further improving the luminance uniformity of the display device 1000. In addition, the light extraction efficiency of the display device 1000 may be improved by the light scattered from the plurality of fine particles, thereby enabling the display device 1000 to operate at lower power.

In the display area AA, a black matrix BM may be disposed on the second electrode CE2, the first optical layer 117a, the second optical layer 117b, and the third optical layer 117c. For example, the contact holes of the second optical layer 117b may be filled with the black matrix BM. The black matrix BM is configured to cover the display area AA, and thus may reduce the color mixing of light from the plurality of sub-pixels and the reflection of external light. For example, the black matrix BM is also disposed in a contact hole in which the second electrode CE2 and the contact electrode CCE are connected, and thus may prevent or reduce light leakage between the plurality of adjacent sub-pixels.

For example, the black matrix BM may be formed of an opaque material, but the embodiments of the present specification are not limited thereto. For example, the black matrix BM may be an organic insulating material containing a black pigment or a black dye, but the embodiments of the present specification are not limited thereto.

In the display area AA, a cover layer 118 may be disposed on the black matrix BM. The cover layer 118 may protect the configuration below the cover layer 118, and for example, the cover layer 118 may be formed of an organic insulating material, but the embodiments of the present specification are not limited thereto. For example, the cover layer 118 may be formed of a photoresist, a polyimide (PI)-based material, a photo acrylic-based material, or the like, but the embodiments of the present specification are not limited thereto. For example, the cover layer 118 may be an overcoating layer, an insulating layer, or the like, but the embodiments of the present specification are not limited thereto.

The polarizing layer 293 may be disposed on the cover layer 118 via a first adhesive layer 291. The cover member 120 may be disposed on the polarizing layer 293 through a second adhesive layer 295. For example, the first adhesive layer 291 and the second adhesive layer 295 may include an optically clear adhesive (OCA), an optically clear resin (OCR), a pressure sensitive adhesive (PSA), or the like, but the embodiments of the present specification are not limited thereto.

According to the present specification, the plurality of pad electrodes PE may be disposed on the third insulating layer 115c in the second non-display area NA2. For example, at least some of the plurality of pad electrodes PE may be exposed from the first passivation layer 116. For example, the plurality of pad electrodes PE may be electrically connected to the 2-4 connection line 122d through contact holes of the third insulating layer 115c.

An adhesive layer ACF may be disposed on the plurality of pad electrodes PE. The adhesive layer ACF may be an adhesive layer in which conductive balls are dispersed in an insulating material, but the embodiments of the present specification are not limited thereto. When heat or pressure is applied to the adhesive layer ACF, the conductive balls at the portions to which the heat or pressure is applied may become electrically connected, thereby exhibiting conductive properties. The adhesive layer ACF may be disposed between the plurality of pad electrodes PE and the flexible circuit board (or flexible film) CB, thereby allowing the flexible circuit board (or flexible film) CB to be attached or bonded to the plurality of pad electrodes PE. For example, the adhesive layer ACF may be an anisotropic conductive film (ACF), but the embodiments of the present specification are not limited thereto.

The flexible circuit board (or flexible film) CB may be disposed on the adhesive layer ACF. The flexible circuit board (or flexible film) CB may be electrically connected to the plurality of pad electrodes PE through the adhesive layer ACF. Accordingly, signals output from the flexible circuit board (or flexible film) CB and the printed circuit board may be transmitted to the pixel driving circuit PD of the display area AA through the plurality of pad electrodes PE, and the 2-4 connection line 122d, the 2-3 connection line 122c, the 2-2 connection line 122b, and the 2-1 connection line 122a. In addition, as shown in FIGS. 8A-8B, the connection lines 121a to 121d may be disposed on a same layer as the connection lines 122a to 122d respectively. For example, the connection lines 121a to 121d, and the connection lines 122a to 122d may be respectively formed of same materials in a same mask process at the same time.

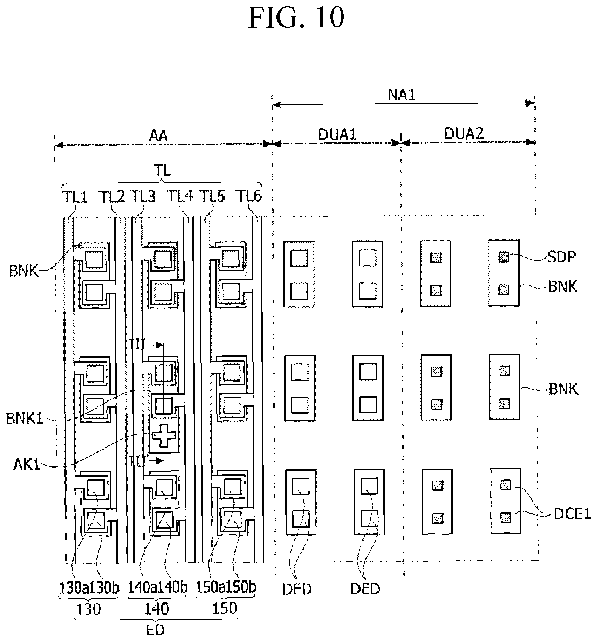

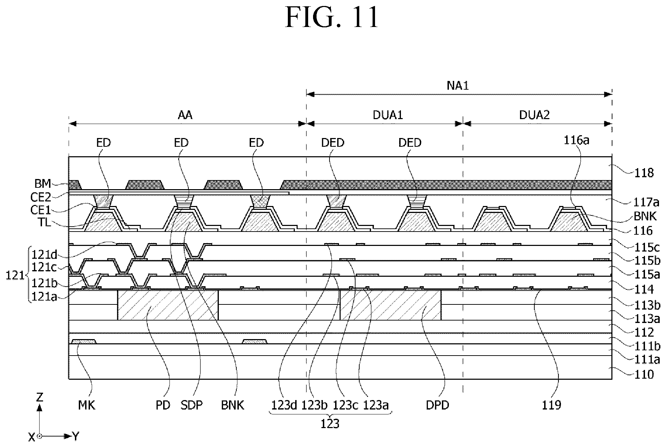

FIG. 10 is an enlarged view of a display device according to an embodiment of the present specification. FIG. 11 is a cross-sectional view of the display device according to the embodiment of the present specification. For example, FIG. 10 may be a partially enlarged view of a display area and a first non-display area. FIG. 11 may be a cross-sectional view of FIG. 10. It is to be noted that although it is shown in FIGS. 5-7 and 10 that in the arrangement of the sub-pixels or the light-emitting elements, the main light-emitting elements are disposed in a same row, while the redundancy light-emitting elements are disposed in another same row, the present disclosure is not limited thereto. For example, within one pixel, one of the main light-emitting elements (for example, the second main light-emitting element) may be disposed in a row where the first redundancy light-emitting element and the third redundancy light-emitting element are disposed and one of the redundancy light-emitting elements (for example, the second redundancy light-emitting element) may be disposed in a row where the first main light-emitting element and the third main light-emitting element are disposed.

Referring to FIGS. 10 and 11, a first non-display area NA1 may be disposed outside a display area AA and adjacent to the display area AA. The first non-display area NA1 may include a first dummy area DUA1 surrounding the display area AA and/or a second dummy area DUA2 surrounding the first dummy area DUA1. The first dummy area DUA1 may be disposed outside the display area AA, and the second dummy area DUA2 may be disposed outside the first dummy area DUA1.

The first dummy area DUA1 may be disposed to provide a process margin during the transfer of light-emitting elements ED. When the transfer is performed only in the display area AA, an area in which the light-emitting element ED is not transferred may occur in the display area AA when a process error occurs at an edge of the display area AA. Accordingly, by performing the transfer over an area wider than the display area AA including the first dummy area DUA1, it is possible to prevent or reduce the light-emitting element ED from failing to be transferred in the display area AA. The second dummy area DUA2 may be disposed for a cutting margin during panel cutting. When the second dummy area DUA2 is not provided, the display area AA may be damaged when a cutting tolerance occurs. For example, cutting may be a trimming process or a dicing process, but the embodiments of the present specification are not limited thereto.

Areas of the first dummy area DUA1 and the second dummy area DUA2 may be adjusted in various ways. For example, the first dummy area DUA1 may be wider than the second dummy area DUA2. For example, the first dummy area DUA1 may be narrower than the second dummy area DUA2. For example, the areas of the first dummy area DUA1 and the second dummy area DUA2 may be the same.

Dummy light-emitting elements DED may be disposed in the first dummy area DUA1. The dummy light-emitting elements DED may be normal light-emitting elements that do not emit light because no power is applied. Signal lines TL may be disposed in the display area AA to be connected first driving electrodes CE1, whereas no line may be disposed in the first dummy area DUA1 and the second dummy area DUA2. Since the first dummy area DUA1 and the second dummy area DUA2 are dummy areas in consideration of tolerance, lines for power application may not be provided thereto. However, the embodiments of the present specification are not limited thereto. For example, lines may also be disposed in the first dummy area DUA1 and the second dummy area DUA2.

Cross-sectional structures of the first dummy area DUA1 and the second dummy area DUA2 may be similar to that of the display area AA. In the first dummy area DUA1 and the second dummy area DUA2, a first buffer layer 111a and a second buffer layer 111b may be disposed on a substrate 110.

An adhesive layer 112 may be disposed on the second buffer layer 111b. The adhesive layer 112 may be formed of any one of an adhesive polymer, an epoxy resin, an ultraviolet (UV)-curable resin, a polyimide-based material, an acrylate-based material, a urethane-based material, and polydimethylsiloxane (PDMS), but the embodiments of the present specification are not limited thereto.

A dummy pixel driving circuit DPD may be disposed on the adhesive layer 112 in the first dummy area DUA1. When the dummy pixel driving circuit DPD is implemented as a driver, a dummy driver may be mounted on the adhesive layer 112 by a transfer process, but the embodiments of the present specification are not limited thereto. The dummy pixel driving circuit DPD may be disposed to match the height of the first dummy area DUA1 with that of the display area AA.

In the second dummy area DUA2, the dummy pixel driving circuit DPD may not be disposed. However, the embodiments of the present specification are not limited thereto. For example, the dummy pixel driving circuit DPD may also be disposed in the second dummy area DUA2.

A first protective layer 113a and a second protective layer 113b may be disposed on the adhesive layer 112 and the dummy pixel driving circuit DPD. The first protective layer 113a and the second protective layer 113b may be disposed to surround side surfaces of the dummy pixel driving circuit DPD, but the embodiments of the present specification are not limited thereto. For example, the second protective layer 113b may be disposed to cover at least a portion of an upper surface of the dummy pixel driving circuit DPD.

The first protective layer 113a and the second protective layer 113b may be formed of an organic insulating material, but the embodiments of the present specification are not limited thereto. For example, the first protective layer 113a and the second protective layer 113b may be formed of a photoresist, a polyimide (PI)-based material, a photo acrylic-based material, or the like, but the embodiments of the present specification are not limited thereto.

According to the present specification, a plurality of connection lines 121 and 123 may be disposed on the second protective layer 113b. The plurality of connection lines 121 and 123 may include a plurality of first connection lines 121 disposed in the display area AA and a plurality of dummy connection lines 123 disposed in the first non-display area NA1 .

The plurality of first connection lines 121 may be lines for electrically connecting a pixel driving circuit PD to the light-emitting elements. Since the plurality of dummy connection lines 123 are dummy lines for matching the height with that of the plurality of first connection lines 121, the plurality of dummy connection lines 123 may not be electrically connected to the dummy pixel driving circuit DPD. However, the present disclosure is not limited thereto. For example, the plurality of dummy connection lines 123 may also be electrically connected to the dummy pixel driving circuit DPD.

The plurality of first connection lines 121 may include a 1-1 connection line 121a, a 1-2 connection line 121b, a 1-3 connection line 121c, and a 1-4 connection line 121d, but the embodiments of the present specification are not limited thereto. The plurality of dummy connection lines 123 may include a 1-1 dummy connection line 123a disposed at the lowest layer, a 1-2 dummy connection line 123b disposed on the 1-1 dummy connection line 123a, a 1-3 dummy connection line 123c disposed on the 1-2 dummy connection line 123b, and a 1-4 dummy connection line 123d disposed on the 1-3 dummy connection line 123c, but the embodiments of the present specification are not limited thereto.

A plurality of 1-1 connection lines 121a and a plurality of 1-1 dummy connection lines 123a may be disposed on the second protective layer 113b. The plurality of 1-1 connection lines 121a may be electrically connected to the pixel driving circuit PD. The plurality of 1-1 connection lines 121a may transmit a voltage output from the pixel driving circuit PD to the first driving electrode CE1 or a second electrode CE2.

The 1-1 dummy connection line 123a may be disposed as the lowest layer among the plurality of dummy connection lines 123 and may be disposed closest to the dummy pixel driving circuit DPD. The 1-1 dummy connection line 123a may be electrically insulated from the dummy pixel driving circuit DPD. The dummy pixel driving circuit DPD may be a dummy driver, but the embodiments of the present specification are not limited thereto.

A third protective layer 114 may be disposed on the second protective layer 113b. The third protective layer 114 may be entirely disposed in the display area AA and the first non-display area NA1. The third protective layer 114 may be formed of an organic insulating material. For example, the third protective layer 114 may be formed of a photoresist, a polyimide (PI)-based material, a photo acrylic-based material, or the like, but the embodiments of the present specification are not limited thereto. For example, the first protective layer 113a, the second protective layer 113b, and the third protective layer 114 may be formed of the same material, but the embodiments of the present specification are not limited thereto.

A plurality of 1-2 connection lines 121b and plurality of 1-2 dummy connection lines 123b may be disposed on the third protective layer 114. The plurality of 1-2 connection lines 121b may be connected to or directly connected to the pixel driving circuit PD.

A first insulating layer 115a may be disposed on the plurality of 1-2 connection lines 121b and the plurality of 1-2 dummy connection lines 123b. The first insulating layer 115a may be entirely disposed in the display area AA and the first non-display area NA1, but the embodiments of the present specification are not limited thereto. The first insulating layer 115a may be formed of an organic insulating material, but the embodiments of the present specification are not limited thereto. For example, the first insulating layer 115a may be formed of a photoresist, a polyimide (PI)-based material, a photo acrylic-based material, or the like, but the embodiments of the present specification are not limited thereto.

A plurality of 1-3 connection lines 121c and a plurality of 1-3 dummy connection lines 123c may be disposed on the first insulating layer 115a. The plurality of 1-3 connection lines 121c may be electrically connected to the plurality of 1-2 connection lines 121b.

A second insulating layer 115b may be disposed on the plurality of 1-3 connection lines 121c and the plurality of 1-3 dummy connection lines 123c. The second insulating layer 115b may be formed of an organic insulating material, but the embodiments of the present specification are not limited thereto. For example, the second insulating layer 115b may be formed of a photoresist, a polyimide (PI)-based material, a photo acrylic-based material, or the like, but the embodiments of the present specification are not limited thereto.

A plurality of 1-4 connection lines 121d and a plurality of 1-4 dummy connection lines 123d may be disposed on the second insulating layer 115b. The plurality of 1-4 connection lines 121d may be electrically connected to the plurality of 1-3 connection lines 121c.

The first protective layer 113a, the second protective layer 113b, the third protective layer 114, the first insulating layer 115a, and the second insulating layer 115b may be formed of an organic insulating material, but the embodiments of the present specification are not limited thereto. For example, the first protective layer 113a, the second protective layer 113b, the third protective layer 114, the first insulating layer 115a, and the second insulating layer 115b may be formed of a photoresist, a polyimide (PI)-based material, a photo acrylic-based material, or the like, but the embodiments of the present specification are not limited thereto. A large amount of gas may be generated from the organic insulating material during the manufacturing process. Since gas cannot pass through an inorganic layer, failure to discharge gas from inside a panel may cause a problem in which the inorganic layer lifts.

Banks BNK may be disposed on the second insulating layer 115b. First electrodes CE1 and DCE1 may be disposed on the banks BNK. The first electrodes CE1 and DCE1 may include the first driving electrodes CE1 disposed on the banks BNK in the display area AA and first dummy electrodes DCE1 disposed on the banks BNK in the first non-display area NA1. The first driving electrode CE1 and the first dummy electrode DCE1 may include the same material. The first driving electrodes CE1 may be electrically connected to the pixel driving circuit PD through the plurality of first connection lines 121. The first dummy electrodes DCE1 may be electrically insulated from the dummy connection lines 123 and the dummy pixel driving circuit DPD.

A solder pattern SDP may be disposed on each of the first driving electrode CE1 and the first dummy electrode DCE1. The solder pattern SDP allows the light-emitting element ED to be bonded to the first driving electrode CE1 and the dummy light-emitting element DED to be bonded to the first dummy electrode DCE1.

A first passivation layer 116 may be disposed on the light-emitting elements ED and the dummy light-emitting elements DED and may include an inorganic insulating material. The first passivation layer 116 may reduce the penetration of moisture or impurities into the light-emitting element ED and the dummy light-emitting element DED. For example, the first passivation layer 116 may be formed as a single layer or multiple layers of silicon oxide (SiOₓ) or silicon nitride (SiNₓ), but the embodiments of the present specification are not limited thereto.

A first optical layer 117a may be disposed to cover a plurality of light-emitting elements ED, a plurality of dummy light-emitting elements DED, and a plurality of banks BNK. For example, the first optical layer 117a may cover the banks BNK, a portion of the first passivation layer 116, spaces between the plurality of light-emitting elements ED and spaces between the plurality of dummy light-emitting elements DED.

The second electrode CE2 may be disposed in the display area AA. The second electrode CE2 may be disposed on the light-emitting elements ED. The second electrodes CE2 may be electrically connected to the pixel driving circuit PD.

The second electrode CE2 may not be disposed in the first non-display area NA1. However, the embodiments of the present specification are not limited thereto. For example, the second electrode CE2 may also be disposed on the dummy light-emitting elements DED. For example, when the dummy connection lines 123 are not electrically connected to the dummy pixel driving circuit DPD, the dummy light-emitting element DED may not emit light even when the second electrode CE2 is disposed on the dummy light-emitting element DED.

A black matrix BM may be entirely disposed in the display area AA and the first non-display area NA1. The black matrix BM may have openings formed in areas corresponding to the light-emitting elements ED in the display area AA, and may be entirely disposed over the dummy light-emitting elements DED in the first non-display area NA1. Since the first dummy area DUA1 and the second dummy area DUA2 are not light-emitting areas, the black matrix BM may be entirely disposed over the first dummy area DUA1 and the second dummy area DUA2.

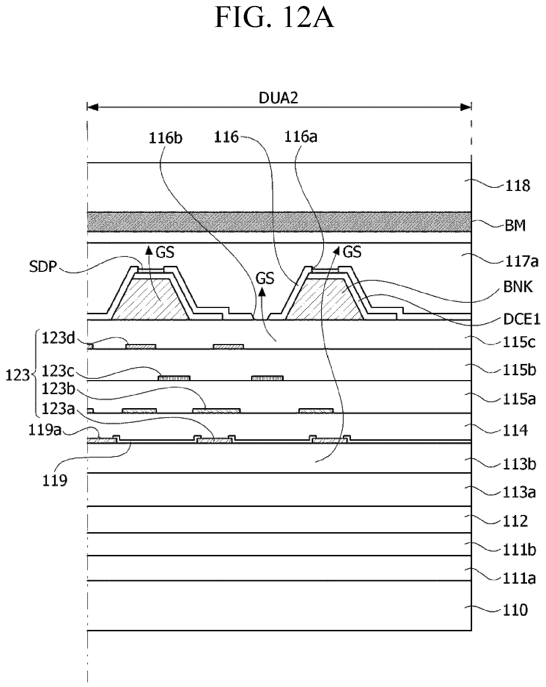

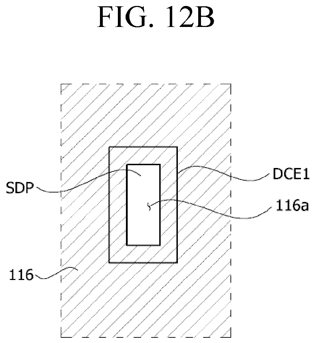

Referring to FIGS. 11, 12A, and 12B, the second dummy area DUA2 may be an area formed to provide a margin at a portion to be diced after panel fabrication. The dummy connection lines 123, which correspond to the first connection lines 121 in the display area AA, may be disposed in the second dummy area DUA2. For example, the first dummy area DUA1 may include the 1-1 dummy connection line 123a, the 1-2 dummy connection line 123b, the 1-3 dummy connection line 123c, and the 1-4 dummy connection line 123d, which respectively correspond to the 1-1 connection line 121a, the 1-2 connection line 121b, the 1-3 connection line 121c, and the 1-4 connection line 121d provided in the display area AA. However, the embodiments of the present specification are not limited thereto. For example, in the second dummy area DUA2, the dummy connection lines 123 may be omitted.

In the second dummy area DUA2, the inorganic light-emitting element ED may not be disposed on the bank BNK, but the embodiments of the present specification are not limited thereto. For example, the dummy light-emitting elements DED may be disposed in at least a portion of the second dummy area DUA2. For example, in the second dummy area DUA2, banks BNK on which the dummy light-emitting elements DED are disposed and banks BNK on which the dummy light-emitting elements DED are not disposed may be alternately disposed, but the present specification is not limited thereto.

The first passivation layer 116 may cover the banks BNK and the first electrodes, which are disposed in the display area AA, the first dummy area DUA1, and the second dummy area DUA2. The first passivation layer 116 may include first openings 116a that are disposed on the first driving electrodes CE1 in the display area AA, and on the first dummy electrodes DCE1 in the first dummy area DUA1 and the second dummy area DUA2. The first driving electrodes CE1 in the display area AA and the first dummy electrodes DCE1 in the first and second dummy areas DUA1 and DUA2 may be exposed through the first openings 116a of the first passivation layer 116.

The light-emitting element ED may be disposed on the first driving electrode CE1, and the dummy light-emitting element DED may be disposed on the first dummy electrode DCE1 in the first dummy area DUA1. In the second dummy area DUA2, the first dummy electrode DCE1 may be in a state in which the dummy light-emitting element DED is not disposed, and only the solder pattern SDP is disposed thereon, but the present disclosure is not limited thereto. In another example, the solder pattern SDP and/or the first dummy electrode DCE1 may also be omitted in the second dummy area DUA2.

In a display device using an inorganic light-emitting element ED, a large amount of gas GS may be generated during the panel fabrication process due to the stacking of a relatively large number of organic layers. According to the embodiment of the present specification, the gas GS may be discharged to the outside through the first openings 116a of the first passivation layer 116. Since the dummy light-emitting elements DED are not stacked on the first openings 116a formed in the second dummy area DUA2, the first openings 116a may remain in an open state. Accordingly, the gas GS may be discharged to the outside through the first openings 116a of the second dummy area DUA2.

According to the embodiment of the present specification, since the dummy light-emitting element DED is not disposed on the first dummy electrode DCE1 in the second dummy area DUA2, the gas GS may be discharged to the outside through the first opening 116a formed in the second dummy area DUA2 even after the light-emitting element ED is transferred. Accordingly, the problem of the first driving electrode CE1, the first dummy electrode DCE1, or the first passivation layer 116 being lifted or shifted by the gas GS may be improved.

The first passivation layer 116 may further include second openings 116b disposed between the banks BNK in the second dummy area DUA2 and/or the first dummy area DUA1. The discharge of the gas GS inside the panel may be facilitated through the second openings 116b. The number of second openings 116b may be greater than the number of first openings 116a in the second dummy area DUA2. However, the embodiments of the present specification are not limited thereto. For example, the number of second openings 116b may be less than the number of first openings 116a in the second dummy area DUA2. When the number of second openings 116b is too large, an adhesion between the first passivation layer 116 and a third insulating layer 115c may be weakened.

According to the embodiment of the present specification, a second passivation layer 119 may be disposed on the 1-1 connection line 121a and the 1-1 dummy connection line 123a. In the second passivation layer 119, third openings 119a may be formed on the 1-1 dummy connection lines 123a in the first dummy area DUA1 and the second dummy area DUA2, so that the gas GS generated from the first protective layer 113a and the second protective layer 113b may be discharged to the outside. Referring to FIG. 12A, the third opening 119a may be disposed on the 1-1 dummy connection line 123a. When the third opening 119a is disposed outside the 1-1 dummy connection line 123a, moisture may penetrate into the inside of a display panel through the third opening 119a. Since the 1-1 dummy connection line 123a is a dummy line that does not affect the performance of the display panel even when lifted or delaminated due to gas discharge, the 1-1 dummy connection line 123a can be configured as a passage for discharging gas.

Referring to FIG. 10, the bank BNK may be disposed for each of a plurality of sub-pixels, and the light-emitting element ED may be disposed on the bank BNK. A first alignment key AK1 for guiding the position of the light-emitting element ED may be disposed on one of the plurality of banks BNK. The bank on which the first alignment key AK1 is disposed may be referred to as an alignment bank BNK1, but the present specification is not limited thereto.

The first alignment key AK1 and the first driving electrode CE1 may be formed at the same time and may have the same layer structure, but the embodiments of the present specification are not limited thereto. For example, the first alignment key AK1 may be formed of a conductive material such as titanium (Ti), aluminum (Al), copper (Cu), molybdenum (Mo), nickel (Ni), chromium (Cr), indium tin oxide (ITO), indium zinc oxide (IZO), or indium gallium zinc oxide (IGZO), but the embodiments of the present specification are not limited thereto.

The first alignment key AK1 may be formed in a multilayer structure of titanium (Ti)/aluminum (Al)/titanium (Ti)/indium tin oxide (ITO), but the embodiments of the present specification are not limited thereto.

The first alignment key AK1 may be disposed on one or more of the plurality of banks BNK. For example, the first alignment key AK1 may be disposed on one of the 16 banks BNK. However, the present specification is not necessarily limited thereto, and the first alignment key AK1 may be disposed on one of the 32 or 64 banks BNK.

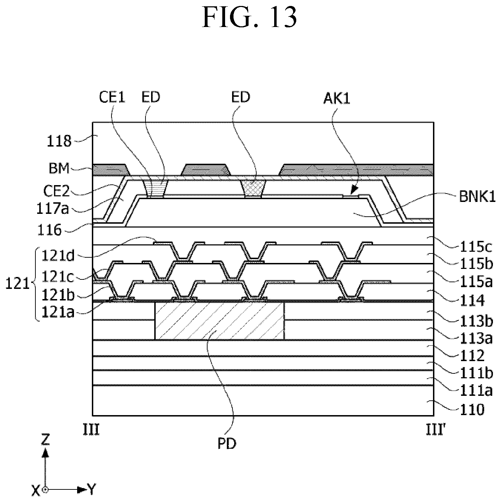

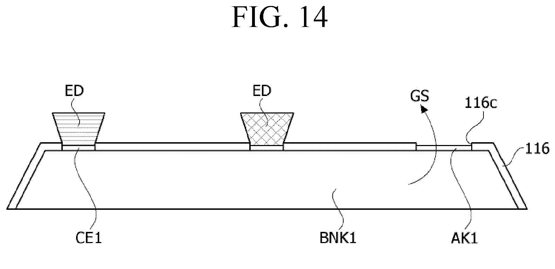

Referring to FIGS. 13 and 14, the first passivation layer 116 may be disposed on the plurality of banks BNK. The first passivation layer 116 may cover the first driving electrodes CE1. The first passivation layer 116 may include a fourth opening 116c disposed on the first alignment key AK1. The bank BNK may be formed of an organic insulating material. The bank BNK may be formed of a single layer or multiple layers of an organic insulating material. Accordingly, gas generated from the bank BNK and the organic layer below the bank BNK may be discharged through the fourth opening 116c. Thus, since the gas GS is discharged through the fourth opening 116c, the phenomenon of the first alignment key AK1 being lifted or shifted may be improved.

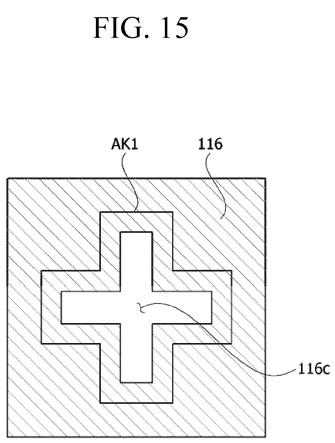

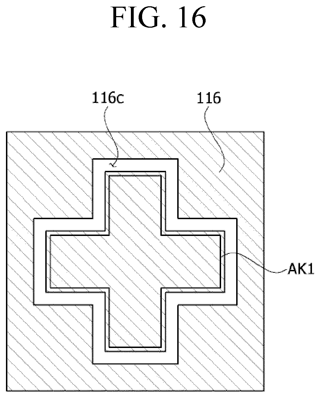

Referring to FIG. 15, the fourth opening 116c may be disposed on the first alignment key AK1. The first passivation layer 116 may cover an edge of the first alignment key AK1, thereby improving the problem of delamination of the first alignment key AK1. However, the embodiments of the present specification are not limited thereto. As shown in FIG. 16, the fourth opening 116c may be disposed so as to surround the first alignment key AK1 while being spaced apart therefrom. Accordingly, the gas GS may be discharged through the fourth opening 116c without passing through the first alignment key AK1, thereby improving the problem of lifting or shifting of the first alignment key AK1. In addition, the first alignment key AK1 may be disposed in various other shapes to perform various guiding or alignment functions necessary for fabricating the display panel.

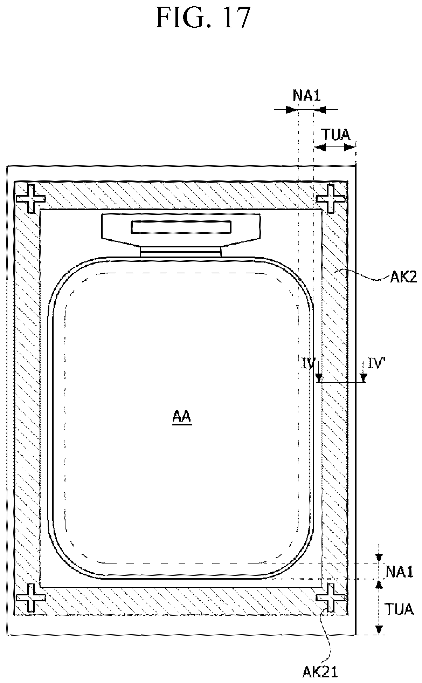

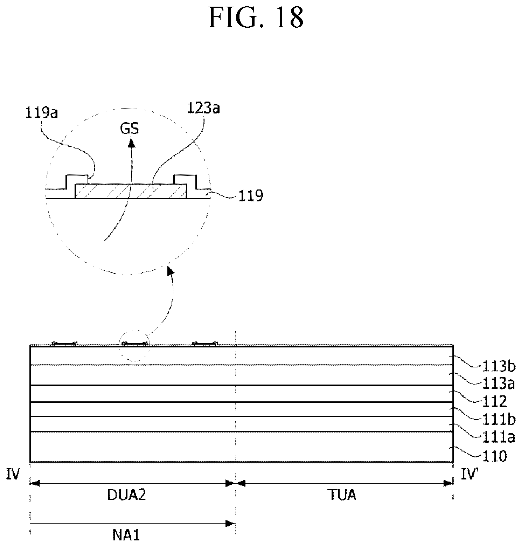

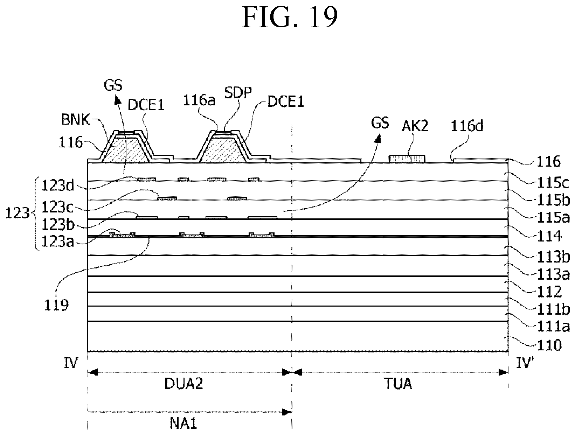

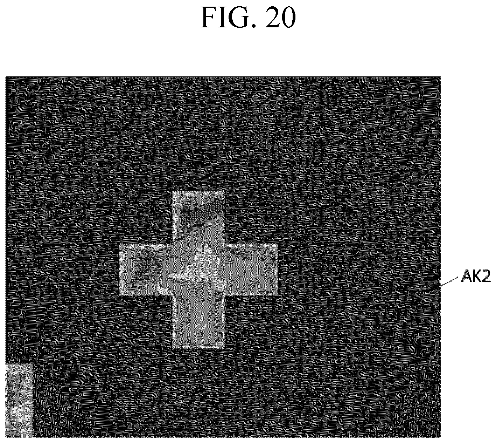

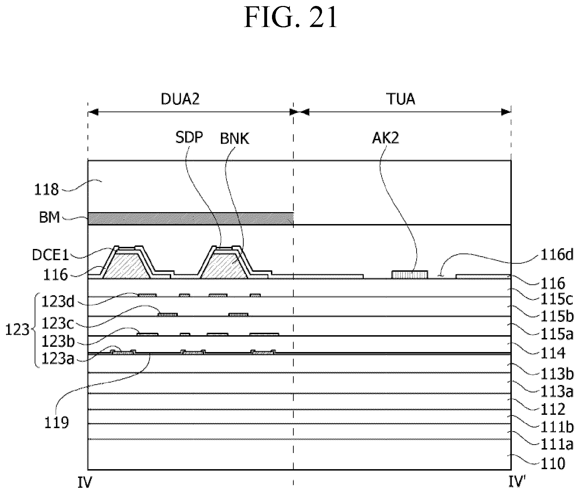

FIG. 17 is a view illustrating a state in which second alignment keys are disposed outside a display device according to an embodiment of the present specification. FIG. 18 is a cross-sectional view of the display device according to the embodiment of the present specification. FIG. 19 is a cross-sectional view of the display device according to the embodiment of the present specification. FIG. 20 is a view illustrating a state in which the second alignment key is delaminated. FIG. 21 is a cross-sectional view of the display device according to the embodiment of the present specification.

Referring to FIG. 17, a substrate 110 may include a display area AA and a first non-display area NA1. A plurality of second alignment keys AK2 may be disposed outside the first non-display area NA1. The second alignment keys AK2 may enable alignment necessary for fabricating a display panel. For example, the second alignment keys AK2 may include an alignment key AK21 that serves as a guide during stacking of a touch panel, an alignment key that serves to align during transfer of a light-emitting element ED, and an alignment key that serves as a guide for a cutting position of the display panel, but the embodiments of the present specification are not limited thereto. The plurality of second alignment keys AK2 may be disposed in different shapes to perform various guiding or alignment functions necessary for fabricating the display panel.

The plurality of second alignment keys AK2 may be disposed to surround the first non-display area NA1 of the display panel. The plurality of second alignment keys AK2 may be disposed on a cutting area TUA, which is an outer area of the first non-display area NA1. The cutting area TUA may be an area that is removed by cutting after the panel fabrication is completed. For example, the cutting area TUA may be a trimming area or a dicing area, but the embodiments of the present specification are not limited thereto.

Referring to FIG. 18, a first buffer layer 111a, a second buffer layer 111b, an adhesive layer 112, a first protective layer 113a, and a second protective layer 113b may be formed on the substrate 110, and 1-1 dummy connection lines 123a may be formed on the second protective layer 113b. The second passivation layer 119 may be formed on the 1-1 dummy connection lines 123a.

The second passivation layer 119 may include a third opening 119a that exposes an upper portion of the 1-1 dummy connection line 123a. Accordingly, gas GS generated in the first protective layer 113a and the second protective layer 113b may be discharged to the outside through the third opening 119a. Thus, the problem of the second passivation layer 119 being lifted due to the gas GS generated in the first protective layer 113a and the second protective layer 113b may be improved.

Referring to FIG. 19, a third protective layer 114, a first insulating layer 115a, a second insulating layer 115b, and a third insulating layer 115c may be formed on the second passivation layer 119. Banks BNK may be formed on the third insulating layer 115c, and a first dummy electrode DCE1 may be formed on the bank BNK. In the cutting area TUA, the second alignment keys AK2 may be formed simultaneously with the first dummy electrodes DCE1.

A first passivation layer 116 may include a first opening 116a exposing the first dummy electrode DCE1 and a fifth opening 116d surrounding the second alignment key AK2. The gas GS generated in an organic layer is discharged through the fifth opening 116d, thereby preventing the second alignment key AK2 from being lifted or delaminated by the gas GS. As shown in FIG. 20, when the second alignment key AK2 is delaminated, identification of the second alignment key may become difficult, which may result in misalignment in a subsequent process.

Referring to FIG. 21, various processes performed after the transfer process may be performed using the second alignment key AK2. In the first non-display area NA1, a black matrix BM may be disposed, and a cover layer 118 may be disposed thereon. After fabrication of the display panel is completed, the cutting area TUA may be removed along a cutting line (or a trimming line or a dicing line).

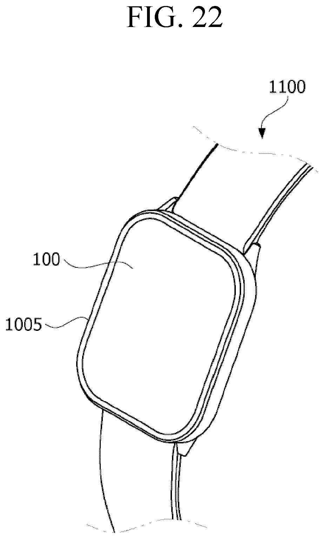

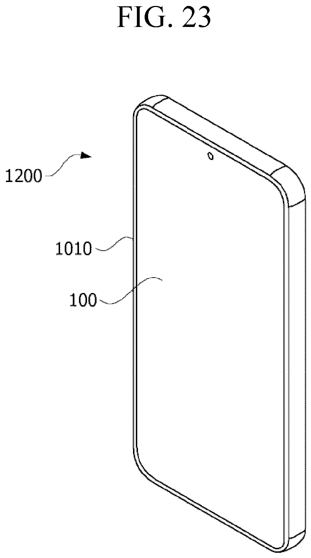

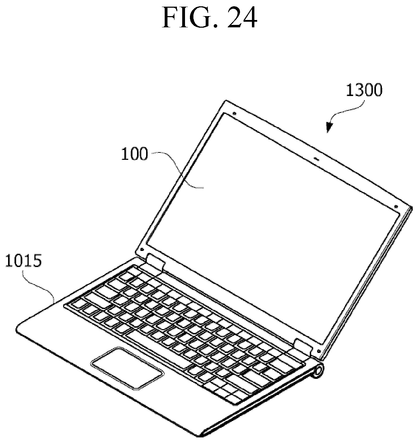

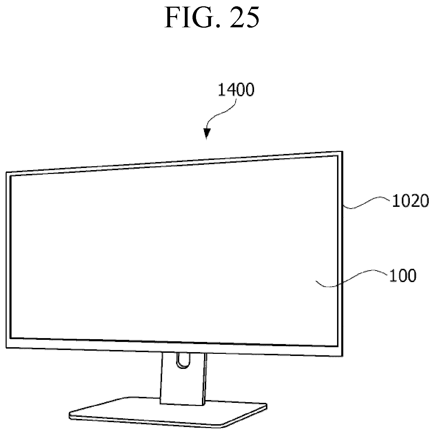

FIGS. 22 to 25 are views illustrating devices to which the display device according to the embodiments of the present specification is applied.

Referring to FIGS. 22 to 25, a display device 1000 according to the embodiments of the present specification may be included in various devices or electronic devices. For example, the various electronic devices may include a wearable device 1100, a mobile device 1200, a laptop computer 1300, and a monitor or TV 1400, but the embodiments of the present specification are not limited thereto.

The wearable device 1100, the mobile device 1200, the laptop computer 1300, and the monitor or TV 1400 may include case parts 1005, 1010, 1015, and 1020, respectively, and may each include the display panel 100 and the display device 1000 according to the embodiments of the present specification described with reference to FIGS. 1 to 15.

For example, the display device according to the embodiment of the present specification may be applied to mobile devices, video phones, smart watches, watch phones, wearable devices, foldable devices, rollable devices, bendable devices, flexible devices, curved devices, sliding devices, variable devices, electronic organizers, e-books, portable multimedia players (PMPs), personal digital assistants (PDAs), MP3 players, mobile medical devices, desktop personal computers (PCs)s, laptop computers, netbook computers, workstations, navigation devices, vehicle display devices, theater display devices, televisions, wallpaper devices, signage devices, gaming devices, laptop computers, monitors, cameras, camcorders, household appliances, and the like.

The display device according to one or more example embodiments of the present specification may be described as follows.

A display device according to one or more embodiments of the present specification may include a substrate including a display area and a non-display area, first electrodes disposed on the substrate, a light-emitting element disposed on each of the first electrodes, and a first passivation layer disposed on the first electrodes. The first electrodes may include a first driving electrode disposed in the display area and a first dummy electrode disposed in the non-display area, and the first passivation layer may include a first opening disposed on the first dummy electrodes.

According to one or more embodiments of the present specification, the display device may further include a plurality of insulating layers disposed on the substrate. The plurality of insulating layers may be disposed below the first electrodes.

According to one or more embodiments of the present specification, the plurality of insulating layers may include an organic material. The first passivation layer may include an inorganic material.

According to one or more embodiments of the present specification, the first opening of the first passivation layer may be disposed on each of the first driving electrodes and the first dummy electrodes.

According to one or more embodiments of the present specification, the display device may further include a driver electrically connected to the first driving electrodes.

According to one or more embodiments of the present specification, the light-emitting element may be electrically connected to the first driving electrode by eutectic bonding.

According to one or more embodiments of the present specification, the light-emitting element may include an anode, a light-emitting structure disposed on the anode, and a cathode disposed on the light-emitting structure.

According to one or more embodiments of the present specification, the non-display area may include a first dummy area disposed outside the display area and a second dummy area disposed outside the first dummy area.

According to one or more embodiments of the present specification, the display device may further include a dummy light-emitting element disposed in the first dummy area.

According to one or more embodiments of the present specification, the display device may further include a dummy driver disposed in the first dummy area, wherein the dummy light-emitting element and the dummy driver may be electrically insulated from each other.

According to one or more embodiments of the present specification, the display device may further include a plurality of banks disposed between the plurality of insulating layers and the first driving electrodes and spaced apart from each other. The light-emitting element may be disposed on each of the plurality of banks.

According to one or more embodiments of the present specification, in the non-display area, the first passivation layer may include a second opening disposed between the plurality of banks.

According to one or more embodiments of the present specification, a plurality of connection lines may include a plurality of first connection lines disposed in the display area and a plurality of dummy connection lines disposed in the non-display area. The plurality of first connection lines may be electrically connected to a pixel driving circuit, and the plurality of dummy connection lines may be electrically insulated from a dummy pixel driving circuit.

According to one or more embodiments of the present specification, the plurality of dummy connection lines may include a 1-1 dummy connection line disposed at the lowest layer.

According to one or more embodiments of the present specification, the display device may further include a second passivation layer disposed on the 1-1 dummy connection line. The second passivation layer may include a third opening disposed on the 1-1 dummy connection line.

According to one or more embodiments of the present specification, the first electrode may include a first alignment key disposed on one of the plurality of banks. The first passivation layer may include a fourth opening disposed on the first alignment key.

According to one or more embodiments of the present specification, the fourth opening may surround the first alignment key while being spaced apart from the first alignment key

According to one or more embodiments of the present specification, the non-display area may include a cutting area disposed outside a second dummy area. The non-display area may further include a second alignment key located in the cutting area. The first passivation layer may further include a fifth opening surrounding the second alignment key.

According to one or more embodiments of the present specification, the display device may further include a first optical layer disposed around a plurality of light-emitting elements, and a second optical layer disposed around the first optical layer.

According to one or more embodiments of the present specification, the first optical layer may be further disposed in the non-display area and overlap the first opening of the first passivation layer.

According to one or more embodiments of the present specification, a solder pattern may be interposed between the first optical layer and the first dummy electrode in the first opening.

According to one or more embodiments of the present specification, the display device may further include a second electrode disposed on the plurality of light-emitting elements, and a third optical layer disposed on the second electrode.

According to one or more embodiments of the present specification, the display device may further include a black matrix disposed on the third optical layer.

According to one or more embodiments of the present specification, each of the plurality of light-emitting elements may include an anode, a first semiconductor layer disposed on the anode, an active layer disposed on the first semiconductor layer, a second semiconductor layer disposed on the active layer, and a cathode disposed on the second semiconductor layer.

According to one or more embodiments of the present specification, the first electrodes are located below the plurality of light-emitting elements and electrically connected to the anodes. The first electrode and the anode may be electrically connected to each other by eutectic bonding through a pattern layer located between the first electrodes and the anodes.

According to one or more embodiments of the present specification, the light-emitting element may be an inorganic light-emitting element.

A display device according to one or more embodiments of the present specification may include a substrate including a display area and a non-display area; first electrodes disposed on the substrate and including a first driving electrode disposed in the display area and a first dummy electrode disposed in the non-display area; a light-emitting element disposed on the first driving electrode; and a first passivation layer disposed on the first electrode, wherein the first passivation layer includes a first opening overlapping the first dummy electrode in the non-display area.

Since the content of the present disclosure described in the summary of the disclosure and the detailed description of exemplary embodiments does not specify essential features of the claims, the scope of the claims is not limited to matters described in the content of the disclosure.

According to the present specification, gas inside a panel can be discharged to the outside, thereby preventing electrodes or alignment keys from lifting or shifting. Accordingly, micro LEDs or panel components can be stacked in accurate positions, thereby providing a display device with improved reliability.

According to the present specification, a display device capable of high-efficiency and low-power driving can be provided by individually controlling a plurality of micro LEDs using a plurality of respective pixel driving circuits.

The effects of the present specification are not limited to the effects mentioned above, and other effects not mentioned can be clearly understood by those skilled in the art to which the technical idea of the present specification pertains from the following description.

While the embodiments of the present disclosure have been described in detail above with reference to the accompanying drawings, the present disclosure is not necessarily limited to these embodiments, and various changes and modifications may be made without departing from the technical spirit of the present disclosure. Accordingly, the embodiments disclosed herein are intended to illustrate and not to limit the technical ideas of the present disclosure, and the scope of the technical ideas of the present disclosure is not limited by these embodiments. Accordingly, the above-described embodiments should be understood to be exemplary and not limiting in any aspect. The scope of the present disclosure should be construed by the appended claims, and all technical ideas within the scope of their equivalents should be construed as being included in the scope of the present disclosure.

## Claims

1. A display device comprising:
a substrate including a display area and a non-display area;
first electrodes disposed on the substrate;
a light-emitting element disposed on each of the first electrodes; and
a first passivation layer disposed on the first electrode,
wherein the first electrodes include a first driving electrode disposed in the display area and a first dummy electrode disposed in the non-display area, and
the first passivation layer includes a first opening disposed on the first dummy electrode.

2. The display device of claim 1, further comprising:
a plurality of insulating layers disposed on the substrate,
wherein the plurality of insulating layers are disposed below the first electrodes.

3. The display device of claim 2, wherein
the plurality of insulating layers include an organic material, and
the first passivation layer includes an inorganic material.

4. The display device of any preceding claim, wherein the first opening of the first passivation layer is disposed on each of the first driving electrode and the first dummy electrode.

5. The display device of any preceding claim 1, further comprising a driver electrically connected to the first driving electrode; and optionally
wherein the light-emitting element is electrically connected to the first driving electrode by eutectic bonding.

6. The display device of any preceding claim, wherein the light-emitting element has a vertical structure including an anode, a light-emitting structure disposed on the anode, and a cathode disposed on the light-emitting structure.

7. The display device of any preceding claim, wherein the non-display area includes a first dummy area disposed outside the display area and a second dummy area disposed outside the first dummy area.

8. The display device of claim 7, further comprising a dummy light-emitting element disposed in the first dummy area.

9. The display device of claim 8, further comprising a dummy driver disposed in the first dummy area,
wherein the dummy light-emitting element and the dummy driver are electrically insulated from each other.

10. The display device of any of claims 2 to 9, further comprising a plurality of banks disposed between the plurality of insulating layers and the first driving electrodes and spaced apart from each other, wherein the light-emitting element is disposed on each of the plurality of banks; and optionally
wherein in the non-display area, the first passivation layer includes a second opening disposed between the plurality of banks.

11. The display device of claim 9, further comprising a plurality of first connection lines disposed in the display area and a plurality of dummy connection lines disposed in the non-display area.

12. The display device of claim 11, wherein the plurality of dummy connection lines include a 1-1 dummy connection line disposed closest to the dummy driver; and optionally
the display device further comprising a second passivation layer disposed on the 1-1 dummy connection line,
wherein the second passivation layer includes a third opening disposed on the 1-1 dummy connection line.

13. The display device of any of claims 10 to 12, wherein
the first electrode includes a first alignment key disposed on one of the plurality of banks, and
the first passivation layer includes a fourth opening disposed on the first alignment key.
wherein the fourth opening surrounds the first alignment key while being spaced apart from the first alignment key.

14. The display device of any of claims 7 to 13, wherein
the non-display area includes a cutting area disposed outside the second dummy area, and further includes a second alignment key located in the cutting area, and
the first passivation layer further includes a fifth opening surrounding the second alignment key.

15. The display device of any preceding claim, further comprising:
a first optical layer disposed around the light-emitting element; and
a second optical layer disposed around the first optical layer,
wherein the first optical layer is further disposed in the non-display area and overlaps the first opening of the first passivation layer,
wherein a solder pattern is interposed between the first optical layer and the first dummy electrode in the first opening; and/or the display device further comprising:
a second electrode disposed on the light-emitting element;
a third optical layer disposed on the second electrode; and
a black matrix disposed on the third optical layer.
